(19) **Europäisches Patentamt / European Patent Office / Office européen des brevets**

(11) **EP 4 099 417 B1**

(12) **EUROPEAN PATENT SPECIFICATION**

(45) Date of publication and mention
of the grant of the patent:
**18.06.2025 Bulletin 2025/25**

(21) Application number: **21781497.9**

(22) Date of filing: **25.02.2021**

(51) International Patent Classification (IPC):
*H10K 59/80* (2023.01)    *H10K 59/40* (2023.01)
*H10K 59/35* (2023.01)    *H10K 102/00* (2023.01)

(52) Cooperative Patent Classification (CPC):
**H10K 59/879; H10K 59/353; H10K 59/40;
H10K 59/873; H10K 59/878;** H10K 59/871;
H10K 59/8731; H10K 2102/3023

(86) International application number:
**PCT/KR2021/002391**

(87) International publication number:
**WO 2021/201440 (07.10.2021 Gazette 2021/40)**

(54) **ELECTRONIC DEVICE INCLUDING DISPLAY**

ELEKTRONISCHE VORRICHTUNG MIT ANZEIGE

DISPOSITIF ÉLECTRONIQUE COMPRENANT UN AFFICHEUR

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.03.2020 KR 20200039399**

(43) Date of publication of application:
**07.12.2022 Bulletin 2022/49**

(60) Divisional application:
**25175672.2**

(73) Proprietor: **Samsung Electronics Co., Ltd.
Suwon-si, Gyeonggi-do 16677 (KR)**

(72) Inventors:
 • **LEE, Jaesung
  Suwon-si Gyeonggi-do 16677 (KR)**
 • **BAE, Jongkon
  Suwon-si Gyeonggi-do 16677 (KR)**
 • **YANG, Byungduk
  Suwon-si Gyeonggi-do 16677 (KR)**
 • **KIM, Hanyuool
  Suwon-si Gyeonggi-do 16677 (KR)**
 • **RYU, Sungwon
  Suwon-si Gyeonggi-do 16677 (KR)**
 • **SHIN, Sungyoung
  Suwon-si Gyeonggi-do 16677 (KR)**
 • **UHM, Minsuk
  Suwon-si Gyeonggi-do 16677 (KR)**

(74) Representative: **Gulde & Partner
Patent- und Rechtsanwaltskanzlei mbB
Berliner Freiheit 2
10785 Berlin (DE)**

(56) References cited:
CN-A- 109 904 347      CN-A- 110 600 518
KR-A- 20160 083 609    KR-A- 20180 135 342
KR-A- 20190 036 936    KR-A- 20190 062 678
KR-A- 20190 112 394    KR-A- 20200 014 599
US-A1- 2015 008 399    US-A1- 2017 316 736
US-A1- 2019 074 339    US-A1- 2019 165 061

**Description**

**[Technical Field]**

Content disclosed in the disclosure relates to a technology for implementing an electronic device including a display and a method for driving the display.

**[Background Art]**

An electronic device may display an image via a display disposed on a surface of a housing. A plurality of pixels for displaying the image may be arranged on the display. The display may receive signals and voltages for displaying the image from a display driver IC (DDI). Each of the plurality of pixels may receive a data voltage corresponding to a brightness and a color of the image to be displayed in a current frame from the display driver IC.

In one example, a display of a general electronic device may be a flat panel display (FPD). The flat panel display may have a wide viewing angle because of being used in an electronic device with a plurality of viewers, such as a TV or a monitor. A display having an ideal wide viewing angle may have a spherical light distribution like a Lambertian surface shape.

Documents (US20190165061A1) and (CN109904347A) disclose conventional organic light emitting display and documents (US20190074339A1) and (US20150008399A1) disclose conventional display devices.

**[Disclosure]**

**[Technical Problem]**

Because a display of a portable electronic device such as a smart phone is viewed by a user from the front and displays personal content, it may be desirable to limit a viewing angle in a direction other than a forward direction.

Various embodiments disclosed in the disclosure are to provide a method for selectively limiting the viewing angle based on a screen displayed on the display and an electronic device to which the method is applied.

**[Technical Solution]**

An electronic device according to one embodiment of the claimed invention includes a housing, a display viewed through at least a portion of the housing and displaying a screen using a plurality of pixels, a display driver IC for providing a data voltage and a light-emission signal for driving each of the plurality of pixels to the display, and a processor operatively connected to the display driver IC, the display includes a transistor layer including a plurality of light emitting elements, an encapsulation layer for covering the transistor layer, a touch electrode disposed on the encapsulation layer, and a protective layer disposed on the touch electrode, the protective layer includes a first area where a first protective layer having a first refractive index is disposed and a second area where a second protective layer having a second refractive index different from the first refractive index is disposed, the second area is disposed to overlap with at least one of the plurality of light emitting elements in a first direction, and a first boundary that is an interface between the first protective layer and the second protective layer forms an inclination of a first angle with the first direction, wherein the processor is configured to control the display driver IC to drive the plurality of light emitting elements arranged in the first area and the second area when the display is in a normal mode for displaying a screen at a first viewing angle and to control the display driver IC to drive only the plurality of light emitting elements arranged in the second area when the display is in a privacy mode for displaying the screen at a second viewing angle narrower than the first viewing angle.

In addition, an electronic device according to another embodiment of the claimed invention disclosed in the disclosure includes a housing, a display viewed through at least a portion of the housing and displaying a screen using a plurality of pixels, a display driver IC for providing a data voltage and a light-emission signal for driving each of the plurality of pixels to the display, and a processor operatively connected to the display driver IC, the display includes a transistor layer including a plurality of light emitting elements, an encapsulation layer for covering the transistor layer, a touch electrode disposed on the encapsulation layer, and a protective layer disposed on the touch electrode, the encapsulation layer includes a first area where a first encapsulation layer having a first refractive index is disposed and a second area where a second encapsulation layer having a second refractive index different from the first refractive index is disposed, the second area is disposed to overlap with at least one of the plurality of light emitting elements in a first direction, and an interface between the first encapsulation layer and the second encapsulation layer forms an inclination of a first angle with the first direction, wherein the display driver IC is controlled to drive the plurality of light emitting elements arranged in the first area and the second area when the display is in a normal mode for displaying a screen at a first viewing angle and the display driver IC is controlled to drive only the plurality of light emitting elements arranged in the second area when the display is in a privacy mode for displaying the screen at a second viewing angle narrower than the first viewing angle.

In addition, a method for controlling a viewing angle of a display of an electronic device according to an embodiment disclosed in the disclosure includes determining whether the electronic device is in a privacy mode, operating the electronic device in the privacy mode or a normal mode, and determining whether an app executed by the electronic device or a page displayed by the display has been switched, the display includes a first area where a first protective layer having a first refractive index is disposed and a second area where a second protective layer having a second refractive index different from the first refractive index is disposed, the second area is disposed to overlap with at least one light emitting element disposed on the display in a first direction, and a first boundary that is an interface between the first protective layer and the second protective layer forms an inclination of a first angle with the first direction.

[ **Advantageous Effects**]

According to the embodiments disclosed in the disclosure, the viewing angle of the display may be limited by concentrating the distribution of the light emitted from the display in the forward direction of the display.

In addition, according to the embodiments disclosed in the disclosure, when it is necessary to reduce the viewing angle based on the screen displayed on the display, the mode of the electronic device may be switched to the privacy mode.

In addition, various effects that are directly or indirectly identified via the disclosure may be provided.

[ **Description of Drawings**]

FIG. 1 is a block diagram illustrating an electronic device in a network environment according to various embodiments.

FIG. 2 is a block diagram illustrating the display device according to various embodiments.

FIG. 3 is a view illustrating a transistor layer, a light emitting element, an encapsulation layer, a touch electrode, a protective layer, and a window of a display according to an embodiment.

FIG. 4 is a view illustrating a transistor layer, a light emitting element, an encapsulation layer, a touch electrode, a protective layer, and a window of a display according to another embodiment.

FIG. 5 is a graph illustrating a reflectance and a transmittance based on an incident angle at which light emitted from a light emitting element is incident on a first boundary according to an embodiment.

FIG. 6 is a view illustrating a viewing angle formed based on first light and second light emitted from a display according to an embodiment.

FIG. 7 is a view illustrating a contrast ratio based on a viewing angle according to an embodiment.

FIG. 8 is a view illustrating a transistor layer, a light emitting element, an encapsulation layer, a touch electrode, a protective layer, and a window of a display according to another embodiment.

FIG. 9 is a graph illustrating a reflectance and a transmittance based on an incident angle at which light emitted from a light emitting element is incident on a first boundary according to another embodiment.

FIG. 10 is a view illustrating a first area and a second area of a display according to an embodiment.

FIG. 11 is a view illustrating a first area and a second area of a display according to another embodiment.

FIG. 12 is a view illustrating a first area and a second area of a display according to another embodiment.

FIG. 13 is a view illustrating a first area and a second area of a display according to another embodiment.

FIG. 14 is a view illustrating a change in a viewing angle based on driving of a first light emitting element and a second light emitting element of a display according to an embodiment, not being part of the claimed invention.

FIG. 15 is a flowchart illustrating a process of determining whether an electronic device is in a privacy mode and then driving the electronic device in a normal mode or the privacy mode according to an embodiment.

FIG. 16 is a front perspective view of an electronic device according to an embodiment.

FIG. 17 is a rear perspective view of an electronic device according to an embodiment.

FIG. 18 is an exploded perspective view of an electronic device according to an embodiment.

In connection with the description of the drawings, the same or similar reference numerals may be used for the same or similar components.

[ **Mode for Invention**]

Hereinafter, various embodiments of the disclosure are described with reference to the accompanying drawings. However, it is not intended to limit the disclosure to specific embodiments, and it should be understood that various modifications, equivalents, and/or alternatives of embodiments of the disclosure are included.

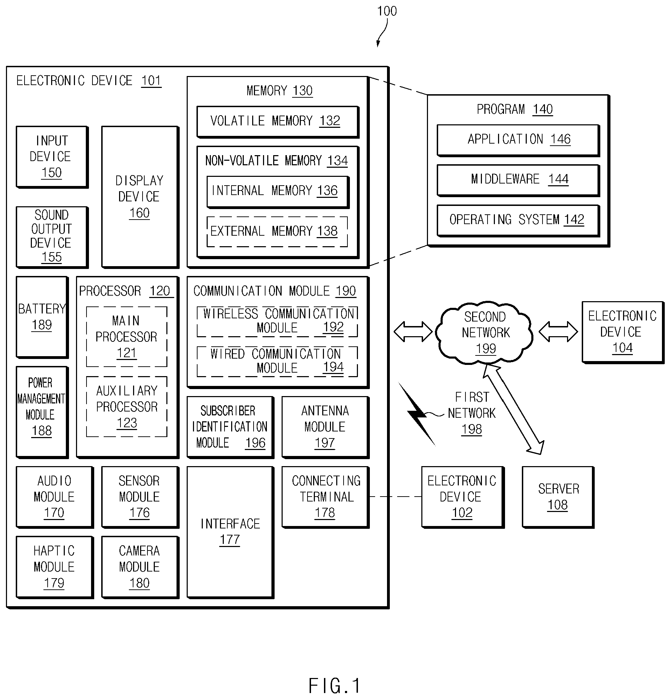

FIG. 1 is a block diagram illustrating an electronic device 101 in a network environment 100 according to various embodiments. Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input device 150, a sound output device 155, a display device 160, an audio module 170, a sensor module 176, an interface 177, a haptic module 179, a camera module 180, a power management module 188, a battery 189, a communication module 190, a subscriber identification module(SIM) 196, or an antenna module 197. In some embodiments, at least one (e.g., the display device 160 or the camera module 180) of the components may be omitted from the electronic device 101, or one or more other components may be added in the electronic device 101. In some embodiments, some of the components may be implemented as single integrated circuitry. For example, the sensor module 176 (e.g., a fingerprint sensor, an iris sensor, or an illuminance sensor) may be implemented as embedded in the display device 160 (e.g., a display).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may load a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), and an auxiliary processor 123 (e.g., a graphics processing unit (GPU), an image signal processor (ISP), a sensor hub processor, or a communication processor (CP)) that is operable independently from, or in conjunction with, the main processor 121. Additionally or alternatively, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display device 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140may be stored in the memory 130 as software, and may include, for example, an operating system (OS) 142, middleware 144, or an application 146.

The input device 150 may receive a command or data to be used by other component (e.g., the processor 120) of the electronic device 101, from the outside (e.g., a user) of the electronic device 101. The input device 150 may include, for example, a microphone, a mouse, a keyboard, or a digital pen (e.g., a stylus pen).

The sound output device 155 may output sound signals to the outside of the electronic device 101. The sound output device 155 may include, for example, a speaker or a receiver. The speaker may be used for general purposes, such as playing multimedia or playing record, and the receiver may be used for an incoming calls. According to an embodiment, the receiver may be implemented as separate from, or as part of the speaker.

The display device 160 may visually provide information to the outside (e.g., a user) of the electronic device 101. The display device 160 may include, for example, a display, a hologram device, or a projector and control circuitry to control a corresponding one of the display, hologram device, and projector. According to an embodiment, the display device 160 may include touch circuitry adapted to detect a touch, or sensor circuitry (e.g., a pressure sensor) adapted to measure the intensity of force incurred by the touch.

The audio module 170 may convert a sound into an electrical signal and vice versa. According to an embodiment, the audio module 170 may obtain the sound via the input device 150, or output the sound via the sound output device 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth™, wireless-fidelity (Wi-Fi) direct, or infrared data association (IrDA)) or the second network 199 (e.g., a long-range communication network, such as a cellular network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., PCB). According to an embodiment, the antenna module 197 may include a plurality of antennas. In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 and 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, or client-server computing technology may be used, for example.

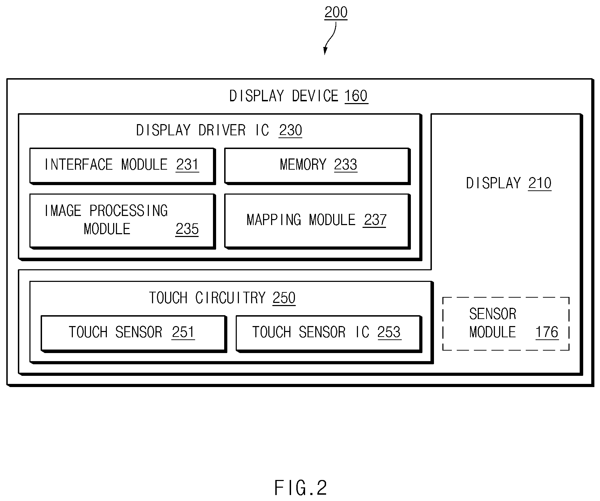

FIG. 2 is a block diagram 200 illustrating the display device 160 according to various embodiments. Referring to FIG. 2, the display device 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 150 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data pre-processed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display device 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display device 160.

According to an embodiment, the display device 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 150)) of the display device 160. For example, when the sensor module 176 embedded in the display device 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display device 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

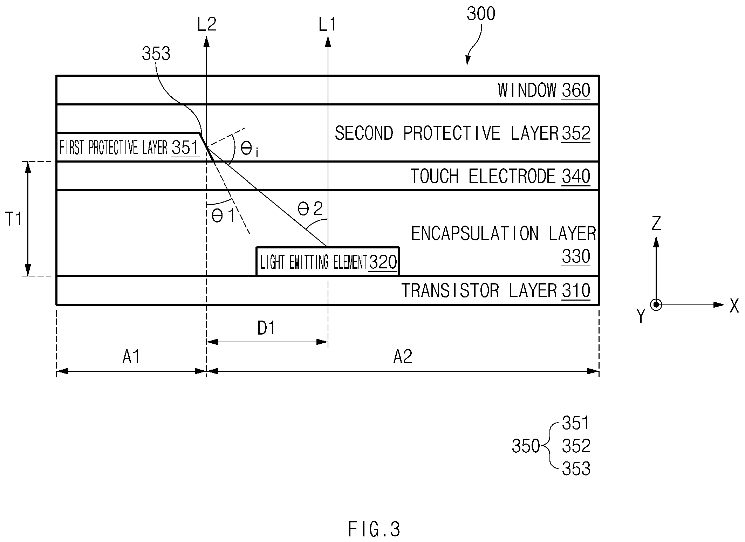

FIG. 3 is a view 300 illustrating a transistor layer 310, a light emitting element 320, an encapsulation layer 330, a touch electrode 340, a protective layer 350, and a window 360 of a display (e.g., the display 210 in FIG. 2) according to an embodiment.

In one embodiment, the transistor layer 310 may form each of the plurality of pixels arranged on the display 210. The transistor layer 310 may include a plurality of thin film transistors (TFTs). The transistor layer 310 may include a driving transistor for driving the light emitting element 320 included in each of the plurality of pixels based on a data voltage and a light-emission control transistor that provides a light-emission signal for controlling a light-emission timing of the light emitting element 320 to the light emitting element 320. The transistor layer 310 may connect the light emitting element 320 to a display driver IC (e.g., the display driver IC 230 in FIG. 2).

In one embodiment, the light emitting element 320 may be included in the transistor layer 310. The light emitting element 320 may be disposed on one surface directed in a first direction (a Z-axis direction) of the transistor layer 310. The light emitting element 320 may be implemented as an organic light emitting diode (OLED). However, the disclosure may not be limited thereto, and the light emitting element 320 may be an active element that emits light at the light-emission timing set by the light-emission signal based on the data voltage.

In one embodiment, the light emitting element 320 may emit first light L1 and second light L2. The first light L1 may be emitted in the first direction (the Z-axis direction). The first light L1 may be emitted to be parallel to a direction in which a front surface of the display 210 is directed. The second light L2 may be emitted in a third direction that is a direction between the first direction (the Z-axis direction) and a second direction (an X-axis direction) perpendicular to the first direction. The third direction may be a direction forming a second angle $\theta 2$ with the first direction (the Z-axis direction). For example, the third direction may be a direction inclined from the first direction (the Z-axis direction) to the second direction (the X-axis direction) by the second angle $\theta 2$. The second light L2 may be emitted in a direction oblique to the direction in which the front surface of the display 210 is directed.

In one embodiment, the encapsulation layer 330 may cover the transistor layer 310 in the first direction (the Z-axis direction). The encapsulation layer 330 may cover the light emitting element 320 in the first direction (the Z-axis direction). The encapsulation layer 330 may be a thin film encapsulation (TFE) layer. The encapsulation layer 330 may prevent the light emitting element 320 from being damaged by an impact and/or external foreign substances.

In one embodiment, the touch electrode 340 may be disposed on the encapsulation layer 330. The touch electrode 340 may be disposed on one surface directed in the first direction (the Z-axis direction) of the encapsulation layer 330. The touch electrode 340 may have a structure in which conductive patterns cross each other in the second direction (the X-axis direction) and a fourth direction (a Y-axis direction) perpendicular to the second direction. For example, the touch electrode 340 may have a metal mesh structure on a XY plane. The touch electrode 340 may be a panel for sensing a touch of a user or a pen. For example, the touch electrode 340 may be formed in an on-cell manner.

In one embodiment, the protective layer 350 may be disposed on the touch electrode 340. The protective layer 350 may be disposed on one surface directed in the first direction (the Z-axis direction) of the touch electrode 340. The protective layer 350 may protect the touch electrode 340 from the impact and/or the external foreign substances. The protective layer 350 may include a first protective layer 351 and a second protective layer 352. The protective layer 350 may include a first area A1 and a second area A2.

In one embodiment, the first protective layer 351 may be disposed in the first area A1. The first protective layer 351 may have a first refractive index n1. For example, the first refractive index n1 may be about 1.5.

In one embodiment, the second protective layer 352 may be disposed in the second area A2. The second protective layer 352 may have a second refractive index n2. The second refractive index n2 may be different from the first refractive index n1. The second refractive index n2 may be greater than the first refractive index n1. For example, the second refractive index n2 may be about 1.7.

In one embodiment, the second area A2 may be disposed to overlap the light emitting element 320 in the first direction (the Z-axis direction). The plurality of light emitting elements 320 may be arranged on the display 210. The second area A2 may overlap with at least one of the plurality of light emitting elements 320 in the first direction (the Z-axis direction).

In one embodiment, a first boundary 353 may be formed at an interface between the first protective layer 351 and the second protective layer 352. The first boundary 353 may form an inclination of a first angle $\theta 1$ with the first direction (the Z-axis direction).

In one embodiment, the second light L2 may travel toward the first boundary 353. The second light L2 may be incident toward the first boundary 353 at an incident angle $\theta i$ formed between the second light L2 and a normal of the first boundary 353.

In one embodiment, the first boundary 353 may control the second light L2 to be directed in the first direction (the Z-axis direction).

7

In one embodiment, the window 360 may be disposed on the protective layer 350. The window 360 may be disposed on one surface directed in the first direction (the Z-axis direction) of the protective layer 350. The window 360 may protect the front surface of the display 210 from the external impact.

In one embodiment, at a boundary between the protective layer 350 and the window 360, an anti-reflection member for preventing light incident from the outside toward the front surface of the display 210 from being reflected may be further disposed. The anti-reflection member may be a polarizing plate or a polarizing film. However, the disclosure may not be limited thereto, and the anti-reflection member may be a plate or a film that prevents the external light from being reflected. In addition, the anti-reflection member may be implemented in a pol-less structure including a color filter layer. For example, the color filter layer may include a color filter and a black pixel defining layer (PDL) having a polarization function.

In one embodiment, a first distance T1 that is a distance in the first direction (the Z-axis direction) between the light emitting element 320 and the second protective layer 352 may be set. The first distance T1 may be a distance in the first direction (the Z-axis direction) between the light emitting element 320 and the first boundary 353. A second distance D1 that is a distance in the second direction (the X-axis direction) between the light emitting element 320 and the first boundary 353 may be set.

In one embodiment, the first angle θ1 may be set based on the first distance T1 and the second distance D1. The first refractive index n1 and the second refractive index n2 may be properties determined by materials constituting the first protective layer 351 and the second protective layer 352. When the first distance T1 and the second distance D1 are set, the incident angle θi of the second light L2 toward the first boundary 353 may be set.

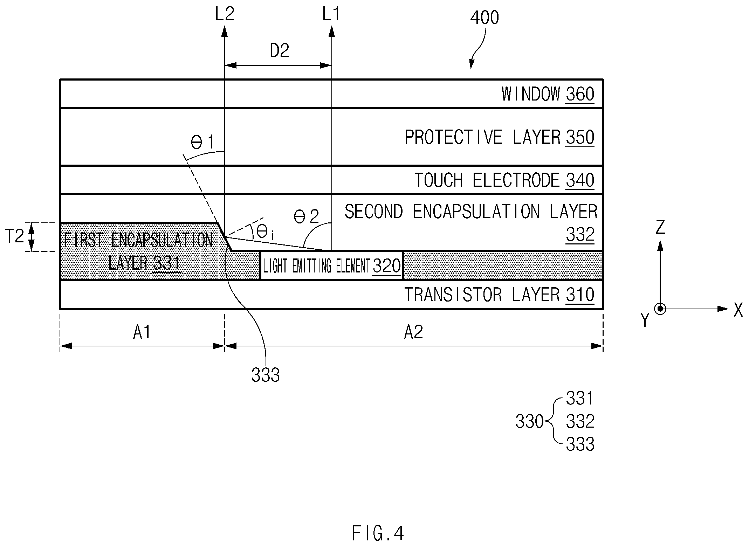

FIG. 4 is a view 400 illustrating the transistor layer 310, the light emitting element 320, the encapsulation layer 330, the touch electrode 340, the protective layer 350, and the window 360 of a display (e.g., the display 210 in FIG. 2) according to another embodiment. A configuration and functions of the transistor layer 310, the light emitting element 320, the touch electrode 340, and the window 360 in FIG. 4 may be substantially the same as the configuration and the functions of the transistor layer 310, the light emitting element 320, the touch electrode 340, and the window 360 in FIG. 4.

The encapsulation layer 330 according to one embodiment may cover the transistor layer 310 and the light emitting element 320. The encapsulation layer 330 may include a first encapsulation layer 331 and a second encapsulation layer 332. The encapsulation layer 330 may include the first area A1 and the second area A2.

In one embodiment, the first encapsulation layer 331 may be disposed in the first area A1. The first encapsulation layer 331 may have the first refractive index n1. For example, the first refractive index n1 may be about 1.5.

In one embodiment, the second encapsulation layer 332 may be disposed in the second area A2. The second encapsulation layer 332 may have the second refractive index n2. The second refractive index n2 may be different from the first refractive index n1. The second refractive index n2 may be greater than the first refractive index n1. For example, the second refractive index n2 may be about 1.7.

In one embodiment, the second area A2 may be disposed to overlap the light emitting element 320 in the first direction (the Z-axis direction). The plurality of light emitting elements 320 may be arranged on the display 210. The second area A2 may overlap with at least one of the plurality of light emitting elements 320 in the first direction (the Z-axis direction).

In one embodiment, an interface 333 between the first encapsulation layer 331 and the second encapsulation layer 332 may form an inclination of the first angle θ1 in the first direction (the Z-axis direction).

In one embodiment, the second light L2 may travel towards the interface 333. The second light L2 may be incident toward the interface 333 at the incident angle θi formed by the second light L2 and a normal of the interface 333.

In one embodiment, the interface 333 may control the second light L2 to be directed in the first direction (the Z-axis direction).

In one embodiment, a third distance T2 that is a distance in the first direction (the Z-axis direction) between the light emitting element 320 and the second encapsulation layer 332 may be set. The third distance T2 may be a distance in the first direction (the Z-axis direction) between the light emitting element 320 and the interface 333. A fourth distance D2 that is a distance in the second direction (the X-axis direction) between the light emitting element 320 and the interface 333 may be set.

In one embodiment, the first angle θ1 may be set based on the third distance T2 and the fourth distance D2. The first refractive index n1 and the second refractive index n2 may be properties determined by materials constituting the first encapsulation layer 331 and the second encapsulation layer 332. When the third distance T2 and the fourth distance D2 are set, the incident angle θi of the second light L2 towards the interface 333 may be set.

Referring to FIGS. 3 and 4, when the first distance T1 and the second angle θ2 are set, the second distance D1 may be calculated based on Mathematical Equation 1. In addition, when the third distance T2 and the second angle θ2 are set, the fourth distance D4 may be calculated based on Mathematical Equation 1.

【Mathematical Equation 1】

$$D = T \times \tan(\theta 2)$$

Referring to FIGS. 3 and 4, when the second angle $\theta 2$ formed by the second light L2 with the first direction (the Z-axis direction) and the incident angle $\theta i$ at which the second light L2 is incident on the first boundary 353 are set, the first angle $\theta 1$ formed by the first boundary 353 with the first direction (the Z-axis direction) may be calculated based on Mathematical Equation 2 below.

【Mathematical Equation 2】

$$\theta 1 = \theta 2 + \theta i - \frac{\pi}{2}$$

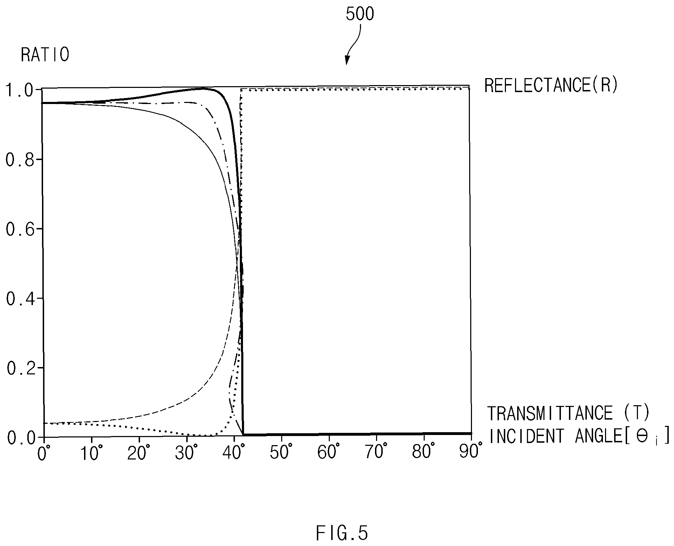

FIG. 5 is a graph 500 illustrating a reflectance R and a transmittance T based on the incident angle $\theta i$ at which light emitted from a light emitting element (e.g., the light emitting element 320 in FIG. 3) is incident on a first boundary (e.g., the first boundary 353 in FIG. 3) according to an embodiment.

In one embodiment, when the light emitted from the light emitting element 320 is incident on the first boundary 353, a portion of the light may be reflected and the remaining portion thereof may travel through the element by the difference in the refractive index between the first protective layer 351 and the second protective layer 352. The first refractive index n1 of the first protective layer 351 and the second refractive index n2 of the second protective layer 352 may be respectively set by the materials respectively constituting the first protective layer 351 and the second protective layer 352. The reflectance R and the transmittance T of the light emitted from the light emitting element 320 may be set based on the incident angle $\theta i$ of the light incident on the first boundary 353. A direction in which the light emitted from the light emitting element 320 travels may be controlled based on the set reflectance R and transmittance T.

In one embodiment, the reflectance R may change as the incident angle $\theta i$ increases. When the incident angle $\theta i$ is equal to or smaller than a first threshold value, the reflectance R may increase as the incident angle $\theta i$ increases. The first threshold value may be equal to or greater than about 35 degrees and equal to or smaller than about 45 degrees. When the incident angle $\theta i$ increases from a value equal to or smaller than the first threshold value to a value equal to or greater than the first threshold value, the reflectance R may increase discontinuously. When the incident angle $\theta i$ is equal to or greater than the first threshold value, the reflectance R may have a value of 1.

In one embodiment, the transmittance T may change as the incident angle $\theta i$ increases. When the incident angle $\theta i$ is equal to or smaller than the first threshold value, the transmittance T may decrease as the incident angle $\theta i$ increases. The first threshold value may be equal to or greater than about 35 degrees and equal to or smaller than about 45 degrees. When the incident angle $\theta i$ increases from the value equal to or smaller than the first threshold value to the value equal to or greater than the first threshold value, the transmittance T may decrease. When the incident angle $\theta i$ is equal to or greater than the first threshold value, the transmittance T may have a value of 0.

In one embodiment, when incident on the first boundary 353, the light emitted from the light emitting element 320 may travel from the second protective layer 352 having the second refractive index n2 toward the first protective layer 351 having the first refractive index n1. The second refractive index n2 may have the value greater than the first refractive index n1. The light emitted from the light emitting element 320 may change the traveling direction thereof while traveling from the second protective layer 352 having a large refractive index to the first protective layer 351 having a small refractive index. The light emitted from the light emitting element 320 may be controlled to be directed in the first direction (the Z-axis direction) by controlling the first refractive index n1 and the second refractive index n2.

In one embodiment, the incident angle $\theta i$ may be set such that an effective reflectance Reff is equal to or greater than a specified value. For example, the incident angle $\theta i$ may be set such that the effective reflectance Reff is equal to or greater than about 0.8. The effective reflectance Reff may be an average value of a S-wave reflectance Rs and a P-wave reflectance Rp. The S-wave reflectance Rs and the P-wave reflectance Rp may be set by the first refractive index n1, the second refractive index n2, and the incident angle $\theta i$. Because the first refractive index n1 and the second refractive index n2 are the values respectively set by the materials respectively constituting the first protective layer 351 and the second protective layer 352, the S-wave reflectance Rs and the P-wave reflectance Rp may be set by the incident angle $\theta i$. Accordingly, the display 210 may be controlled to have the desired effective reflectance Reff by controlling the incident angle $\theta i$.

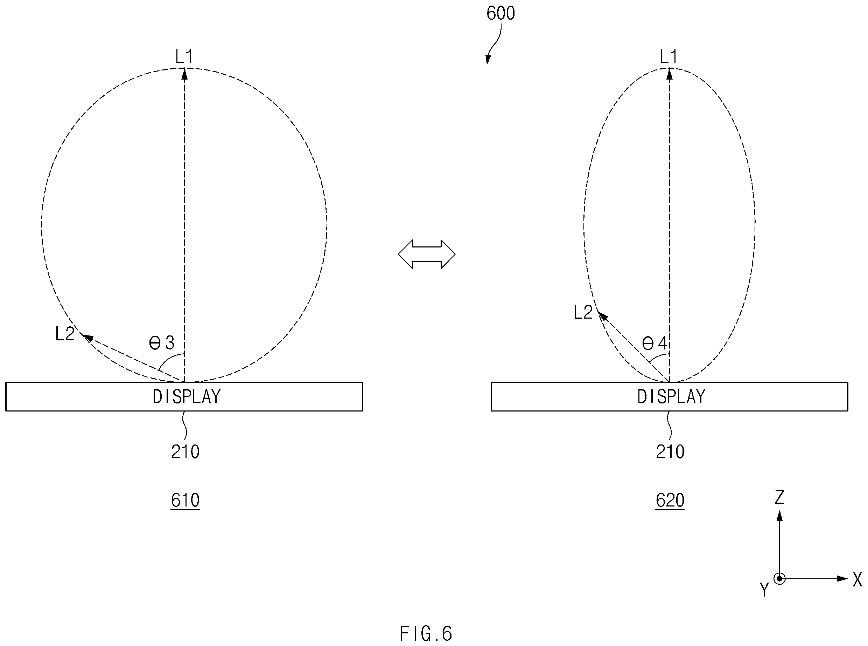

FIG. 6 is a view 600 illustrating a viewing angle formed based on the first light L1 and the second light L2 emitted from the display 210 according to an embodiment.

In one embodiment, the display 210 may have a Lambertian-shaped light distribution. An angle between the first light L1 and the second light L2 in a first situation 610 may be a third angle $\theta 3$. An angle between the first light L1 and the second light L2 in a second situation 620 may be a fourth angle θ4.

In one embodiment, a viewing angle (VA) of the display 210 may be set based on the angle between the first light L1 and the second light L2. The first situation 610 where the angle between the first light L1 and the second light L2 is the third angle θ3 may be a normal mode in which the display 210 displays a screen at a first viewing angle. The second situation 620 where the angle between the first light L1 and the second light L2 is the fourth angle θ4 may be a privacy mode in which the display 210 displays the screen at a second viewing angle that is narrower than the first viewing angle.

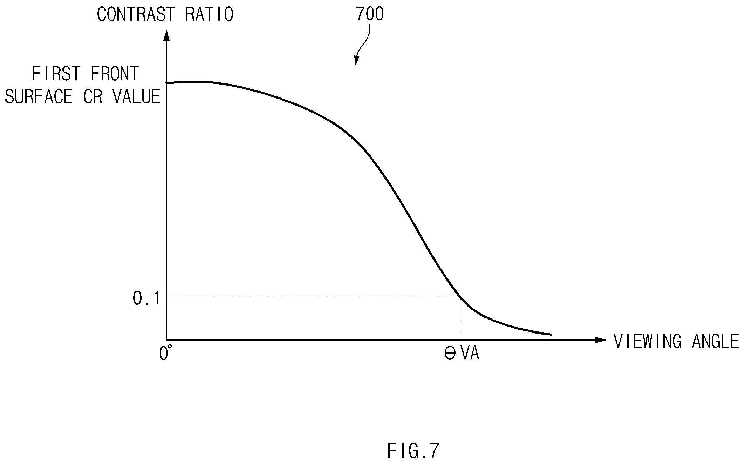

FIG. 7 is a view 700 illustrating a contrast ratio based on a viewing angle according to an embodiment.

In one embodiment, a contrast ratio (CR) of the display 210 may be changed as a magnitude of the viewing angle at which the user views the display 210 changes. When the user views the front surface of the display 210, the contrast ratio may be a first front surface contrast ratio value. The first front surface contrast ratio value may be a ratio between a luminance of a central portion in a full white screen and a luminance of a central portion in a full black screen. The first front surface contrast ratio value as a viewing angle determined by a specification of the display 210 may have a maximum value in a forward direction. For example, the first front surface CR value may have a value equal to or greater than about 1000 and equal to or smaller than about 1000000. As the magnitude of the viewing angle at which the user views the display 210 increases, the contrast ratio may decrease.

In one embodiment, a viewing angle θVA of the display 210 may be defined as an angle at which the contrast ratio has a specified value. For example, the viewing angle θVA of the display 210 may be defined as an angle at which the contrast ratio is about 0.1. When a viewing angle with respect to the forward direction when the contrast ratio is about 0.1 times is about 80 degrees, the viewing angle θVA of the display 210 may be defined as about 80 degrees.

In one embodiment, the display 210 of the portable electronic device 101 may be used by a single viewer viewing the display 210 from the front in most scenarios. When the viewing angle θVA of the display 210 is limited, the user may not expose personal content displayed on the display 210 in a direction other than the forward direction of the display 210.

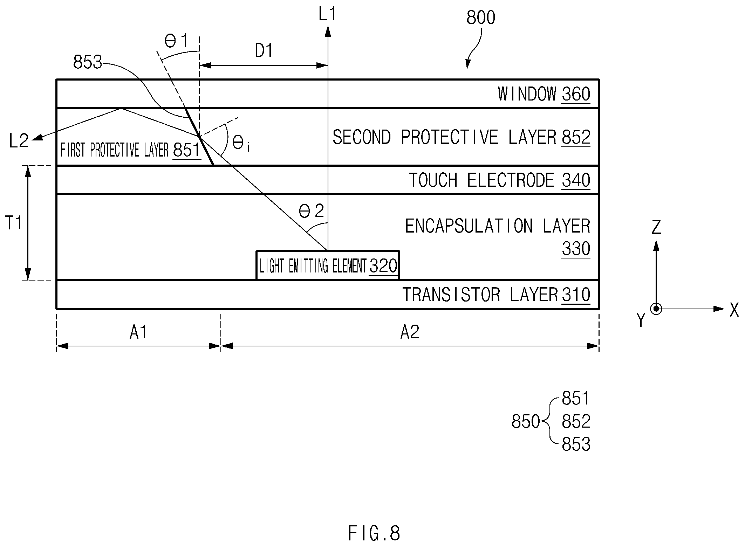

FIG. 8 is a view 800 illustrating the transistor layer 310, the light emitting element 320, the encapsulation layer 330, the touch electrode 340, a protective layer 850, and the window 360 of a display (e.g., the display 210 in FIG. 2) according to another embodiment. The transistor layer 310, the light emitting element 320, the encapsulation layer 330, and the touch electrode 340 of the display 210 according to FIG. 8 may have substantially the same configuration and functions as the configuration and the functions of the transistor layer 310, the light emitting element 320, the encapsulation layer 330, and the touch electrode 340 of the display 210 according to FIG. 3.

In one embodiment, the protective layer 850 may be disposed on the touch electrode 340. The protective layer 850 may be disposed on one surface directed in the first direction (the Z-axis direction) of the touch electrode 340. The protective layer 850 may protect the touch electrode 340 from the impact and/or the external foreign substances. The protective layer 850 may include a first protective layer 851 and a second protective layer 852. The protective layer 850 may include the first area A1 and the second area A2.

In one embodiment, the first protective layer 851 may be disposed in the first area A1. The first protective layer 851 may have the first refractive index n1. For example, the first refractive index n1 may be about 1.5.

In one embodiment, the second protective layer 852 may be disposed in the second area A2. The second protective layer 852 may have the second refractive index n2. The second refractive index n2 may be different from the first refractive index n1. The second refractive index n2 may be smaller than the first refractive index n1. For example, the second refractive index n2 may be about 1.3.

In one embodiment, the second area A2 may be disposed to overlap the light emitting element 320 in the first direction (the Z-axis direction). The plurality of light emitting elements 320 may be arranged on the display 210. The second area A2 may overlap at least one of the plurality of light emitting elements 320 in the first direction (the Z-axis direction).

In one embodiment, a first boundary 853 may be formed at an interface between the first protective layer 851 and the second protective layer 852. The first boundary 853 may form an inclination of the first angle θ1 with the first direction (the Z-axis direction).

In one embodiment, the second light L2 may travel toward the first boundary 853. The second light L2 may be incident toward the first boundary 853 at the incident angle θi formed by the second light L2 and the normal of the first boundary 353.

In one embodiment, the first boundary 853 may control the second light L2 to be bent in the second direction (the X-axis direction). The second light L2 having an emission angle of the second angle θ2 from the light emitting element 320 may be refracted at an angle greater than the second angle θ2.

In one embodiment, the window 360 may be disposed on the protective layer 850. The window 360 may be disposed on one surface directed in the first direction (the Z-axis direction) of the protective layer 850. The window 360 may protect the front surface of the display 210 from the external impact.

In one embodiment, the first refractive index n1 of the first protective layer 851 may be greater than a refractive index of the window 360. The second light L2 may travel from a dense medium having a great refractive index to a sparse medium having a small refractive index. The second light L2 may be totally reflected at an interface between the protective layer 850 and the window 360. The totally reflected second light L2 may not be emitted to the outside of the display 210, and may travel inwardly of the display 210 or may be lost. The viewing angle of the display 210 may be limited by not emitting the second light L2 emitted from the light emitting element 320 to the outside.

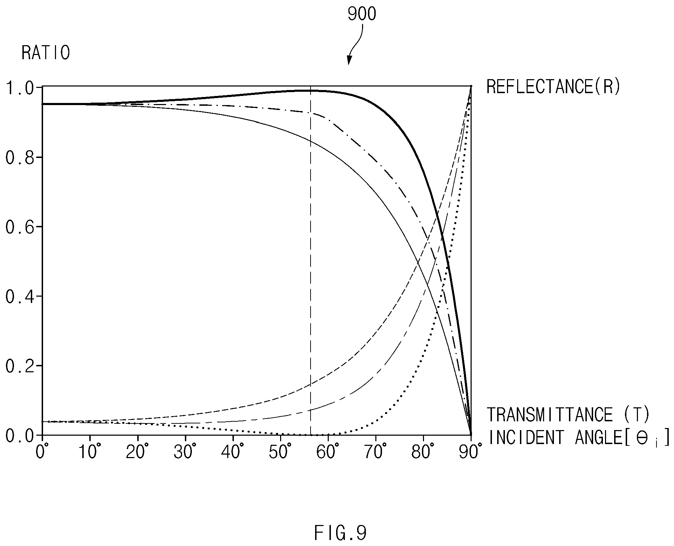

FIG. 9 is a graph 900 illustrating a reflectance and the transmittance T based on the incident angle $\theta i$ at which light emitted from a light emitting element (e.g., the light emitting element 320 in FIG. 8) is incident on a first boundary (e.g., the first boundary 853 in FIG. 8) according to another embodiment.

In one embodiment, when the light emitted from the light emitting element 320 is incident on the first boundary 853, a portion of the light may be reflected and the remaining portion thereof may travel through the element by the difference in the refractive index between the first protective layer 851 and the second protective layer 852. The first refractive index n1 of the first protective layer 851 and the second refractive index n2 of the second protective layer 852 may be respectively set by the materials respectively constituting the first protective layer 851 and the second protective layer 852. The reflectance and the transmittance T of the light emitted from the light emitting element 320 may be set based on the incident angle $\theta i$ of the light incident on the first boundary 853. A direction in which the light emitted from the light emitting element 320 travels may be controlled based on the set reflectance and transmittance T.

In one embodiment, the reflectance may change as the incident angle $\theta i$ increases. When the incident angle $\theta i$ is equal to or smaller than a second threshold value, the reflectance may decrease as the incident angle $\theta i$ increases. The second threshold value may be equal to or greater than about 50 degrees and equal to or smaller than about 60 degrees. When the incident angle $\theta i$ is a value equal to or smaller than the second threshold value, the reflectance R may have a value close to zero. When the incident angle $\theta i$ increases to a value equal to or greater than the second threshold value, the reflectance may increase. When the incident angle $\theta i$ is about 90 degrees, the reflectance may have a value close to one.

In one embodiment, the transmittance T may change as the incident angle $\theta i$ increases. When the incident angle $\theta i$ is equal to or smaller than the second threshold value, the transmittance T may increase as the incident angle $\theta i$ increases. The second threshold value may be equal to or greater than about 50 degrees and equal to or smaller than about 65 degrees. When the incident angle $\theta i$ is a value equal to or smaller than the second threshold value, the transmittance T may have a value close to one. When the incident angle $\theta i$ increases to the value equal to or greater than the second threshold value, the transmittance T may increase. When the incident angle $\theta i$ is about 90 degrees, the transmittance T may have a value close to zero.

In one embodiment, the light emitted from the light emitting element 320 may travel toward the first protective layer 851 having the first refractive index n1 from the second protective layer 852 having the second refractive index n2 when incident on the first boundary 853. The second refractive index n2 may have the smaller value than the first refractive index n1. The light emitted from the light emitting element 320 may change the traveling direction thereof while traveling from the second protective layer 852 having the small refractive index to the first protective layer 851 having the great refractive index. The light emitted from the light emitting element 320 may be controlled to be totally reflected at the interface between the protective layer 850 and the window 360 by controlling the first refractive index n1 and the second refractive index n2.

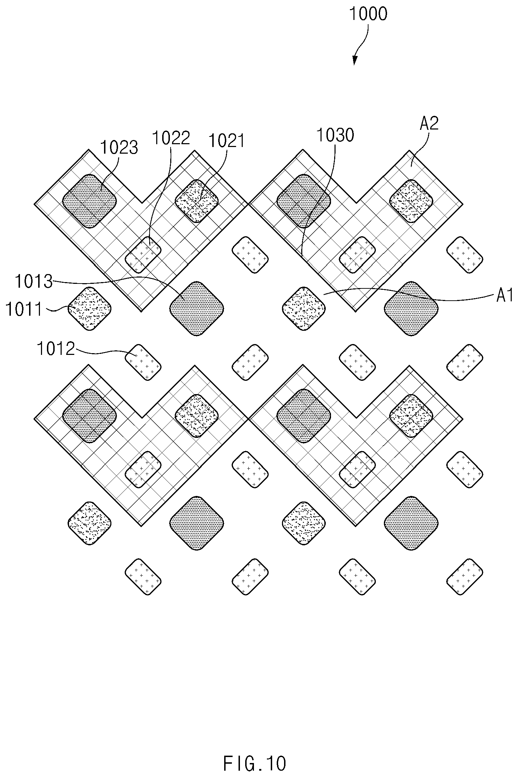

FIG. 10 is a view 1000 illustrating the first area A1 and the second area A2 of a display (e.g., the display 210 in FIG. 2) according to an embodiment.

In one embodiment, a plurality of light emitting elements (e.g., the light emitting element 320 in FIG. 3) may include red sub-pixels 1011 and 1021, green sub-pixels 1012 and 1022, and blue sub-pixels 1013 and 1023. The first area A1 may include the at least one red sub-pixel 1011, the at least one green sub-pixel 1012, and the at least one blue sub-pixel 1013. The second area A2 may include the at least one red sub-pixel 1021, the at least one green sub-pixel 1022, and the at least one blue sub-pixel 1023.

In one embodiment, a first boundary 1030 may be formed between the first area A1 and the second area A2. The first boundary 1030 may divide the first area A1 and the second area A2 from each other. The first boundary 1030 may be formed as long as possible between the first area A1 and the second area A2.

In one embodiment, the first boundary 1030 may be formed between each two of the plurality of pixels formed in the display 210. The first boundary 1030 may be formed in units of pixels. The first boundary 1030 may be formed as wide as possible between the first area A1 and the second area A2.

In one embodiment, a processor (e.g., the processor 120 in FIG. 1) of an electronic device (e.g., the electronic device 101 in FIG. 1) may be set to control a display driver IC (e.g., the display driver IC 230 in FIG. 2) to drive the plurality of light emitting elements 1011, 1012, 1013, 1021, 1022, and 1023 arranged in the first area A1 and the second area A2 in case of the normal mode in which the display 210 displays the screen at the first viewing angle. The display driver IC 230 may be set to turn on all of the pixels arranged in the first area A1 and the second area A2, so that the display 210 displays a screen having a general viewing angle.

In one embodiment, the processor 120 of the electronic device 101 may be set to control the display driver IC 230 to drive the plurality of light emitting elements 1021, 1022, and 1023 arranged in the second area A2 in the case of the privacy mode in which the display 210 displays the screen at the second viewing angle narrower than the first viewing angle. The display driver IC 230 may be set to selectively turn on only the pixels arranged in the second area A2, so that the display 210 displays a screen having a narrow viewing angle.

In one embodiment, when only the light emitting elements 1021, 1022, and 1023 arranged in the second area A2 are turned on, an arrangement of the turned on light emitting elements 1021, 1022, and 1023 may be different from an arrangement in the case in which all of the plurality of light emitting elements 1011, 1012, 1013, 1021, 1022, and 1023 arranged in the first area A1 and the second area A2 are turned on. For example, when only the light emitting elements 1021, 1022, and 1023 arranged in the second area A2 are turned on in FIG. 10, the arrangement of the light emitting elements 1021, 1022, and 1023 may change to become an RGB pixel arrangement so as to be different from a pentile pixel arrangement of the plurality of light emitting elements 1011, 1012, 1013, 1021, 1022, and 1023 arranged in the first area A1 and the second area A2. When only the light emitting elements 1021, 1022, and 1023 arranged in the second area A2 are turned on, rendering and gamma tuning for the red sub-pixel 1021, the green sub-pixel 1022, and the blue sub-pixel 1023 may be changed in the display driver IC 230 based on the change in the pixel arrangement.

In one embodiment, when only the light emitting elements 1021, 1022, and 1023 arranged in the second area A2 are turned on, a luminance of the display 210 may be about 37.5 % of that in the case in which all of the plurality of light emitting elements 1011, 1012, 1013, 1021, 1022, and 1023 arranged in the first area A1 and the second area A2 are turned on. When all of the plurality of light emitting elements 1011, 1012, 1013, 1021, 1022, and 1023 arranged in the first area A1 and the second area A2 are turned on, the number of effective pixels for each unit area may be 16. In addition, when only the light emitting elements 1021, 1022, and 1023 arranged in the second area A2 are turned on, the number of effective pixels for each unit area may be 4.

In one embodiment, a processor (e.g., the processor 120 in FIG. 1) of an electronic device (e.g., the electronic device 101 in FIG. 1) may implement various embodiments in relation to a method for recognizing whether to switch the mode of the electronic device to the normal mode and/or the privacy mode.

In one embodiment, the processor 120 may switch the mode of electronic device in an entirety of the display 210 to the normal mode and/or the privacy mode via setting of the electronic device 101 or a menu of a quick panel. When switching the mode of the electronic device to the normal mode and/or the privacy mode via the setting of the electronic device 101 or the menu of the quick panel, all applications may operate in the normal mode or the privacy mode in each corresponding mode.

In one embodiment, the processor 120 may set an application to operate in the privacy mode. For example, the processor 120 may set a bank application as the application operating in the privacy mode. The processor 120 may switch the mode of the display 210 from the normal mode to the privacy mode when the application operating in the privacy mode is executed. For example, the processor 120 may switch the mode of the display 210 from the normal mode to the privacy mode when the bank application is executed while maintaining the normal mode in a state of displaying a home screen. The processor 120 may set the application operating in the privacy mode based on a predetermined condition, or the user may set whether to operate in the privacy mode for each application.

In one embodiment, the processor 120 may switch the mode of the display 210 from the normal mode to the privacy mode when executing a specific function of a specific application. For example, the processor 120 may switch the mode of the display 210 from the normal mode to the privacy mode when executing a secret mode and/or a secret tap function of a browser application.

In one embodiment, the processor 120 may switch the display 210 from the normal mode to the privacy mode when a function of inputting specific information is executed. For example, the processor 120 may switch the mode of the display 210 from the normal mode to the privacy mode when the user activates a function of inputting personal information such as an ID and/or a password.

In one embodiment, the processor 120 may switch a mode of at least a partial area of the display 210 to the privacy mode when the display 210 simultaneously displays execution screens of a plurality of applications when the plurality of applications are executed. The display 210 may simultaneously display the execution screens of the plurality of applications with a split screen such as a multi window or a pop-up screen. When a plurality of applications including the application operating in the privacy mode are executed, the processor 120 may drive an entire area of the display 210 in the privacy mode or may drive only an area in which the application operating in the privacy mode is displayed in the privacy mode.

In one embodiment, the processor 120 may switch the mode of the display 210 to the privacy mode based on an operation of a sensor (e.g., the sensor module 176 in FIG. 1). For example, the processor 120 may switch the mode of the display 210 to the privacy mode when the electronic device 101 is raised to a vertical level of a user's face or when both eyes of the user are sensed.

In one embodiment, the processor 120 may switch the mode of the display 210 to the privacy mode based on a folded state and/or an unfolded state of the foldable electronic device 101. For example, the processor 120 may switch the mode of the display 210 to the privacy mode when the display 210 of the electronic device 101 is folded in a book mode or the like.

In one embodiment, the processor 120 may switch the mode of the display 210 to the privacy mode based on a reduced state and/or an expanded state of the screen of the rollable display 210 that may be rolled and unrolled. For example, the processor 120 may switch the mode of the display 210 to the privacy mode when the screen of the display 210 of the electronic device 101 is in the expanded state. The processor 120 may switch the mode of the display 210 to the privacy mode so as to prevent the screen from being viewed from a side of the display 210 when a screen view area in which the screen may be viewed is increased.

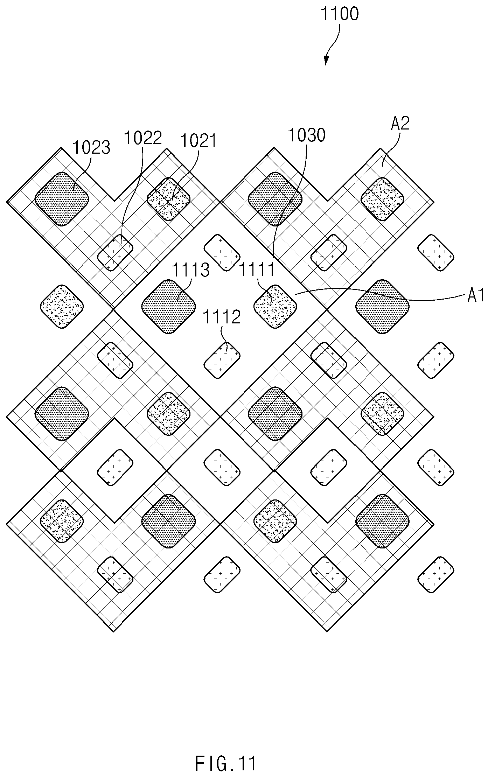

FIG. 11 is a view 1100 illustrating the first area A1 and the second area A2 of a display (e.g., the display 210 in FIG. 2) according to another embodiment.

In one embodiment, a plurality of light emitting elements (e.g., the light emitting element 320 in FIG. 3) may include red sub-pixels 1111 and 1021, green sub-pixels 1112 and 1022, and blue sub-pixels 1113 and 1023. The first area A1 may include the at least one red sub-pixel 1111, the at least one green sub-pixel 1112, and the at least one blue sub-pixel 1113. The second area A2 may include the at least one red sub-pixel 1021, the at least one green sub-pixel 1022, and the at least one blue sub-pixel 1023.

In one embodiment, the first boundary 1030 may be formed between each two of the plurality of pixels formed in the display 210. The first boundary 1030 may be formed in units of pixels.

In one embodiment, when only the light emitting elements 1021, 1022, and 1023 arranged in the second area A2 are turned on, the arrangement of the light emitting elements 1021, 1022, and 1023 may change to become the RGB pixel arrangement so as to be different from a pentile pixel arrangement of the plurality of light emitting elements 1111, 1112, 1113, 1021, 1022, and 1023 arranged in the first area A1 and the second area A2. When only the light emitting elements 1021, 1022, and 1023 arranged in the second area A2 are turned on, the rendering and the gamma tuning for the red sub-pixel 1021, the green sub-pixel 1022, and the blue sub-pixel 1023 may be changed in the display driver IC 230 based on the change in the pixel arrangement.

In one embodiment, when only the light emitting elements 1021, 1022, and 1023 arranged in the second area A2 are turned on, the luminance of the display 210 may be about 50 % of that in the case in which all of the plurality of light emitting elements 1111, 1112, 1113, 1021, 1022, and 1023 arranged in the first area A1 and the second area A2 are turned on. When all of the plurality of light emitting elements 1111, 1112, 1113, 1021, 1022, and 1023 arranged in the first area A1 and the second area A2 are turned on, the number of effective pixels for each unit area may be 16. In addition, when only the light emitting elements 1021, 1022, and 1023 arranged in the second area A2 are turned on, the number of effective pixels for each unit area may be 6.

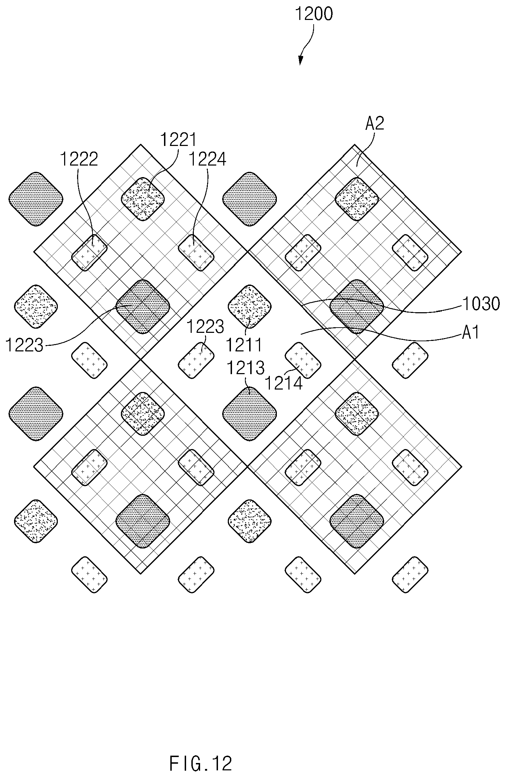

FIG. 12 is a view 1200 illustrating the first area A1 and the second area A2 of a display (e.g., the display 210 in FIG. 2) according to another embodiment.

In one embodiment, a plurality of light emitting elements (e.g., the light emitting element 320 in FIG. 3) may include red sub-pixels 1211 and 1221, green sub-pixels 1212, 1214, 1222, and 1224, and blue sub-pixels 1213 and 1223. The first area A1 may include the at least one red sub-pixel 1211, the at least one green sub-pixel 1212, the at least one green sub-pixel 1214, and the at least one blue sub-pixel 1213. The second area A2 may include the at least one red sub-pixel 1221, the at least one green sub-pixel 1222, the at least one green sub-pixel 1224, and the at least one blue sub-pixel 1223.

In one embodiment, the first boundary 1030 may be formed between the first area A1 and the second area A2. The first boundary 1030 may divide the first area A1 and the second area A2 from each other.

In one embodiment, the first boundary 1030 may be formed between each two of the plurality of pixels formed in the display 210. The first boundary 1030 may be formed in units of pixels.

In one embodiment, a processor (e.g., the processor 120 in FIG. 1) of an electronic device (e.g., the electronic device 101 in FIG. 1) may be set to control a display driver IC (e.g., the display driver IC 230 in FIG. 2) to drive the plurality of light emitting elements 1211, 1212, 1213, 1214, 1221, 1222, 1223, and 1224 arranged in the first area A1 and the second area A2 in case of the normal mode in which the display 210 displays the screen at the first viewing angle. The display driver IC 230 may be set to turn on all of the pixels arranged in the first area A1 and the second area A2, so that the display 210 displays the screen having the general viewing angle.

In one embodiment, the processor 120 of the electronic device 101 may be set to control the display driver IC 230 to drive the plurality of light emitting elements 1221, 1222, 1223, and 1224 arranged in the second area A2 in the case of the privacy mode in which the display 210 displays the screen at the second viewing angle narrower than the first viewing angle. The display driver IC 230 may be set to selectively turn on only the pixels arranged in the second area A2, so that the display 210 displays the screen having the narrow viewing angle.

In one embodiment, even when only the light emitting elements 1221, 1222, 1223, and 1224 arranged in the second area A2 are turned on, an arrangement of the turned on light emitting elements 1221, 1222, 1223, and 1224 may be maintained the same as an arrangement in the case in which all of the plurality of light emitting elements 1211, 1212, 1213, 1214, 1221, 1222, 1223, and 1224 arranged in the first area A1 and the second area A2 are turned on. For example, when only the light emitting elements 1221, 1222, 1223, and 1224 arranged in the second area A2 are turned on in FIG. 12, an arrangement of the light emitting elements 1221, 1222, 1223, and 1224 may change to become a pentile pixel arrangement so as to maintain the same pixel arrangement as a pentile pixel arrangement of the plurality of light emitting elements 1211, 1212, 1213, 1214, 1221, 1222, 1223, and 1224 arranged in the first area A1 and the second area A2.

In one embodiment, when only the light emitting elements 1221, 1222, 1223, and 1224 arranged in the second area A2 are turned on, the luminance of the display 210 may be about 50 % of that in the case in which all of the plurality of light emitting elements 1211, 1212, 1213, 1214, 1221, 1222, 1223, and 1224 arranged in the first area A1 and the second area A2 are turned on. When all of the plurality of light emitting elements 1211, 1212, 1213, 1214, 1221, 1222, 1223, and 1224 arranged in the first area A1 and the second area A2 are turned on, the number of effective pixels for each unit area may be 16. In addition, when only the light emitting elements 1221, 1222, 1223, and 1224 arranged in the second area A2 are turned on, the number of effective pixels for each unit area may be 8.

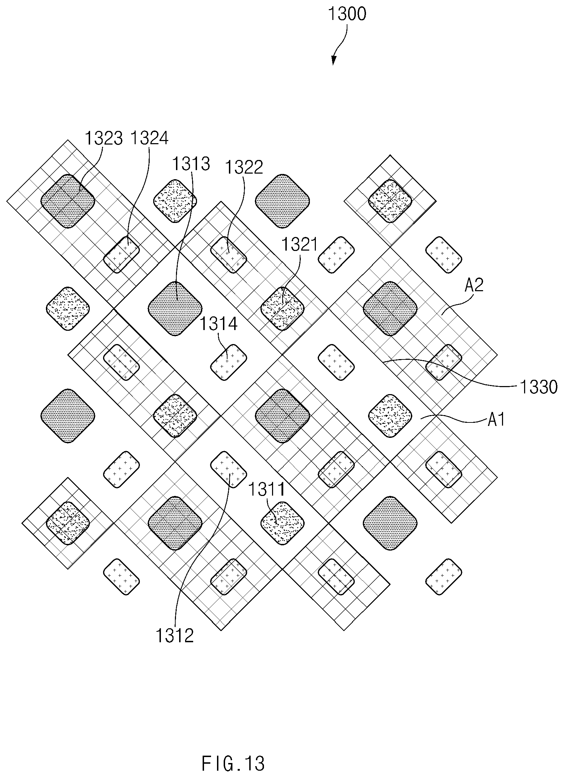

FIG. 13 is a view 1300 illustrating the first area A1 and the second area A2 of a display (e.g., the display 210 in FIG. 2) according to another embodiment.

In one embodiment, a plurality of light emitting elements (e.g., the light emitting element 320 in FIG. 3) may include red sub-pixels 1311 and 1321, green sub-pixels 1312, 1314, 1322, and 1324, and blue sub-pixels 1313 and 1323. The first area A1 may include the at least one red sub-pixel 1311, the at least one green sub-pixel 1312, the at least one green sub-pixel 1314, and the at least one blue sub-pixel 1313. The second area A2 may include the at least one red sub-pixel 1321, the at least one green sub-pixel 1322, the at least one green sub-pixel 1324, and the at least one blue sub-pixel 1323.

In one embodiment, a first boundary 1330 may be formed between the first area A1 and the second area A2. The first boundary 1030 may divide the first area A1 and the second area A2 from each other.

In one embodiment, the first boundary 1030 may be formed between each two of the plurality of pixels formed in the display 210. The first boundary 1030 may be formed in units of pixels.

In one embodiment, a processor (e.g., the processor 120 in FIG. 1) of an electronic device (e.g., the electronic device 101 in FIG. 1) may be set to control a display driver IC (e.g., the display driver IC 230 in FIG. 2) to drive the plurality of light emitting elements 1311, 1312, 1313, 1314, 1321, 1322, 1323, and 1324 arranged in the first area A1 and the second area A2 in case of the normal mode in which the display 210 displays the screen at the first viewing angle. The display driver IC 230 may be set to turn on all of the pixels arranged in the first area A1 and the second area A2, so that the display 210 displays the screen having the general viewing angle.

In one embodiment, the processor 120 of the electronic device 101 may be set to control the display driver IC 230 to drive the plurality of light emitting elements 1321, 1322, 1323, and 1324 arranged in the second area A2 in the case of the privacy mode in which the display 210 displays the screen at the second viewing angle narrower than the first viewing angle. The display driver IC 230 may be set to selectively turn on only the pixels arranged in the second area A2, so that the display 210 displays the screen having the narrow viewing angle.

In one embodiment, when only the light emitting elements 1321, 1322, 1323, and 1324 arranged in the second area A2 are turned on, an arrangement of the light emitting elements 1321, 1322, 1323, and 1324 may change to become a pentile pixel arrangement so as to maintain the same pixel arrangement as a pentile pixel arrangement of the plurality of light emitting elements 1311, 1312, 1313, 1314, 1321, 1322, 1323, and 1324 arranged in the first area A1 and the second area A2.

In one embodiment, when only the light emitting elements 1321, 1322, 1323, and 1324 arranged in the second area A2 are turned on, the luminance of the display 210 may be about 50 % of that in the case in which all of the plurality of light emitting elements 1311, 1312, 1313, 1314, 1321, 1322, 1323, and 1324 arranged in the first area A1 and the second area A2 are turned on. When all of the plurality of light emitting elements 1311, 1312, 1313, 1314, 1321, 1322, 1323, and 1324 arranged in the first area A1 and the second area A2 are turned on, the number of effective pixels for each unit area may be 16. In addition, when only the light emitting elements 1321, 1322, 1323, and 1324 arranged in the second area A2 are turned on, the number of effective pixels for each unit area may be 8.

In FIGS. 10 to 13, the display 210 of a RGB structure including the red sub-pixel, the green sub-pixel, and the blue sub-pixel is illustrated. However, the disclosure may not be limited thereto, and each of pixels including one or more sub-pixels of different colors may be disposed on the display 210. For example, the display 210 may include pixels of an RGBW structure including the red sub-pixel, the green sub-pixel, the blue sub-pixel, and a white sub-pixel. As another example, the display 210 may include pixels of a CMY structure including a cyan sub-pixel, a magenta sub-pixel, and a yellow sub-pixel. A plurality of sub-pixels may be included in one of the plurality of pixels, and may emit light with a specified color. In this regard, the second area may include sub-pixels of different colors of the plurality of sub-pixels, and the number of each of the sub-pixels of the different colors may be equal to or greater than one. Accordingly, even when only the second area is driven in the privacy mode, the display 210 may express all colors.

In addition, in the content described above in connection with FIGS. 10 to 13, the method for reducing the viewing angle of the display 210 regardless of the colors of the sub-pixels such as the red sub-pixel, the green sub-pixel, and the blue sub-pixel was mainly described. However, the disclosure may not be limited thereto, and the processor 120 may apply a method for reducing the viewing angle only to a sub-pixel of a specified color to generate color distortion in the display 210, thereby reducing visibility. For example, in the privacy mode in which the display 210 displays the screen at the second viewing angle that is narrower than the first viewing angle, the processor 210 may selectively turned off the green sub-pixels (e.g., the green sub-pixel 1012 in FIG. 10) and the blue sub-pixels (e.g., the blue sub-pixel 1013 in FIG. 10) among the plurality of sub-pixels arranged in the first area A1. In this case, a complete color may be expressed when the display 210 is viewed from the front, and an image may be expressed in red as green and blue are excluded when the display 210 is viewed from the side. The processor 120 may implement the privacy mode such that it is not easy to distinguish the content of the screen because of the color distortion in the screen of the display 210 when the display 210 is viewed from the side.

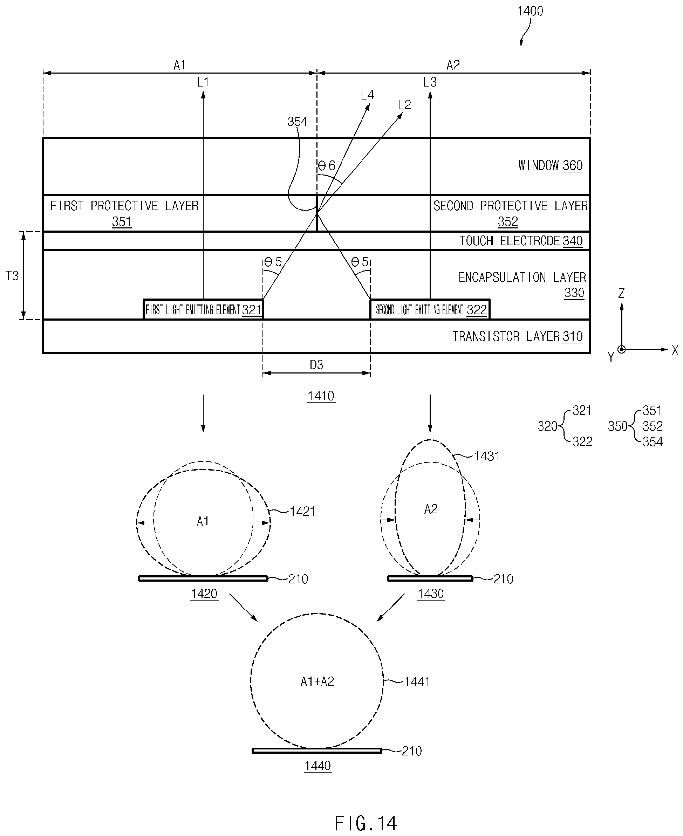

FIG. 14 is a view 1400 illustrating a change in a viewing angle based on driving of a first light emitting element 321 and a second light emitting element 322 of a display (e.g., the display 210 in FIG. 2) according to an embodiment, not forming part of the claimed invention. The transistor layer 310, the encapsulation layer 330, the touch electrode 340, and the window 360 in FIG. 14 may have substantially the same configuration and functions as the configuration and the functions of the transistor layer 310, the encapsulation layer 330, the touch electrode 340, and the window 360 in FIG. 3.

In one embodiment, referring to a cross-sectional view 1410, a distance from the plurality of light emitting elements 320 to the protective layer 350 may be a fifth distance T3. The plurality of light emitting elements 320 may include the first light emitting element 321 and the second light emitting element 322. Each of the first light emitting element 321 and the second light emitting element 322 may define a pixel. A distance between the first light emitting element 321 and the second light emitting element 322 may be a sixth distance D3.

In one embodiment, the first light emitting element 321 may be disposed in the first area A1. The first light emitting element 321 may emit the first light L1 and the second light L2. The first light L1 may be emitted in the first direction (the Z-axis direction). The second light L2 may be emitted in the third direction between the first direction (the Z-axis direction) and the second direction (the X-axis direction).

In one embodiment, the second light emitting element 322 may be disposed in the second area A2. The second light emitting element 322 may emit third light L3 and fourth light L4. The third light L3 may be emitted in the first direction (the Z-axis direction). The fourth light L4 may be emitted in the fourth direction between the first direction (the Z-axis direction) and the second direction (the X-axis direction).

In one embodiment, the protective layer 350 may include the first protective layer 351 and the second protective layer 352. The first protective layer 351 may be disposed in the first area A1. The first protective layer 351 may have the first refractive index n1. The second protective layer 352 may have the second refractive index n2. The second refractive index n2 may be greater than the first refractive index n1. A second boundary 354 may be formed between the first protective layer 351 and the second protective layer 352.

In one embodiment, the second light L2 and the fourth light L4 may travel toward the second boundary 354. The second light L2 may be refracted in the second direction (the X-axis direction) at the second boundary 354. The fourth light L4 may be totally reflected at the second boundary 354 and emitted to the second area A2.

In one embodiment, referring to a wide viewing angle mode 1420, when only the first light emitting element 321 in the first area A1 is driven, the viewing angle of the display 210 may be a wide optical viewing angle 1421. In the wide viewing angle mode 1420, the viewing angle of the display 210 may be increased by the refraction of the second light L2.

In one embodiment, referring to a privacy mode 1430, when only the second light emitting element 322 in the second area A2 is driven, the viewing angle of the display 210 may be a narrow viewing angle 1431. In the privacy mode 1430, the viewing angle of the display 210 may be reduced by the reflection of the fourth light L4.

In one embodiment, referring to a normal mode 1440, when both the first light emitting element 321 in the first area A1 and the second light emitting element 322 in the second area A2 are driven, the viewing angle of the display 210 may be a first viewing angle 1441 combining the wide viewing angle 1421 and the narrow viewing angle 1431. In the normal mode 1440, a viewing angle may have a Lambertian distribution substantially the same as that of the general display 210.

In one embodiment, a processor (e.g., the processor 120 in FIG. 1) of an electronic device (e.g., the electronic device 101 in FIG. 1) may be set to control a display driver IC (e.g., the display driver IC 230 in FIG. 2) to drive the plurality of light emitting elements 321 and 322 arranged in the first area A1 and the second area A2 in the case of the normal mode 1440 in which the display 210 displays the screen at the first viewing angle 1441. The processor 120 of the electronic device 101 may be set to control the display driver IC 230 to drive the plurality of light emitting elements 322 arranged in the second area A1 in the case of the privacy mode 1430 in which the display 210 displays the screen at the second viewing angle 1431 that is the narrow viewing angle 1431 narrower than the first viewing angle.

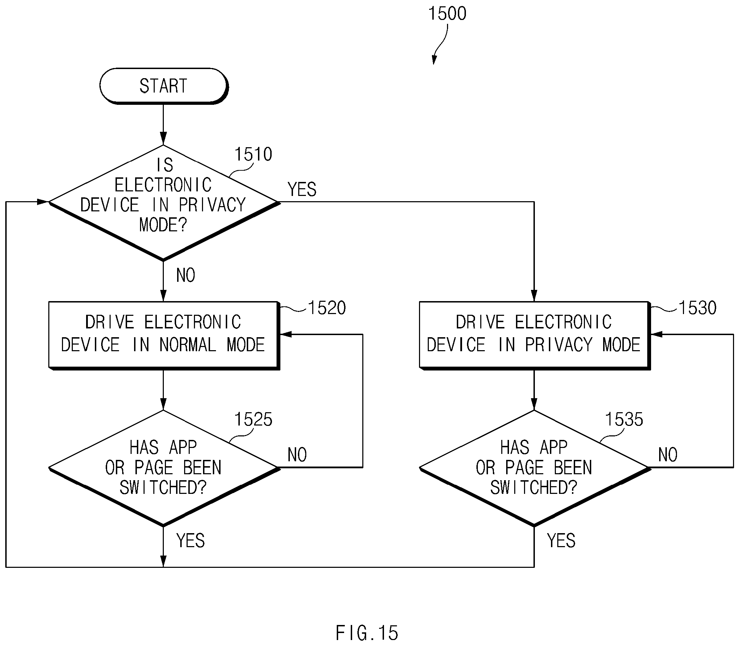

FIG. 15 is a flowchart 1500 illustrating a process of determining whether an electronic device (e.g., the electronic device 101 in FIG. 1) is in a privacy mode (e.g., the privacy mode 1430 in FIG. 14) and then driving the electronic device in a normal mode (e.g., the normal mode 1440 in FIG. 14) or the privacy mode 1430 according to an embodiment.

In operation 1510, a processor (e.g., the processor 120 in FIG. 1) of the electronic device 101 according to an embodiment may determine whether the electronic device 101 is in the privacy mode 1430. The processor 120 may identify an application (e.g., the application 146 in FIG. 1) that is being executed on the electronic device 101 or displaying a screen on a display (e.g., the display 210 in FIG. 2). The processor 120 may determine whether the electronic device 101 is in the privacy mode 1430 depending on a type of the application 146. For example, the processor 120 may determine that the electronic device 101 is in the privacy mode 1430 when the application 146 is a messenger, an e-mail, a social media app, and a photo gallery. As another example, the processor 120 may determine that the electronic device 101 is in the privacy mode 1430 when executing the e-mail, the social media, or a separate user-specified page in a web browser or displaying the e-mail, the social media, or the separate user-specified page on the screen. When the electronic device 101 is not in the privacy mode 1430 (operation 1510 - NO), the processor 120 may proceed to operation 1520. When the electronic device 101 is in the privacy mode 1430 (operation 1510 - YES), the processor 120 may proceed to operation 1530.

In one embodiment, the processor 120 may activate the privacy mode 1430 based on a place where the electronic device 101 is located and/or an environment around the electronic device 101. For example, the processor 120 may activate the privacy mode 1430 so as to prevent other people from viewing the display 210 when a public Wi-Fi supported by a subway or a cafe is connected to a wireless communication module (e.g., the wireless communication module 192 in FIG. 1) or when it is identified using a global positioning system (GPS) that the place where the electronic device 101 is located is a public place. As another example, when an illuminance around the electronic device 101 is equal to or smaller than a specified illuminance, the processor 120 may activate the privacy mode 1430 so as to reduce an effect on surrounding people by light emitted from the display 210 in directions other than a direction in which the front surface of the display 210 is directed.

The processor 120 of the electronic device 101 according to an embodiment may be driven in the normal mode 1440 in operation 1520. The electronic device 101 may be driven in the normal mode 1440 when the type of the application 146 being executed or the screen displayed on the display 210 does not correspond to the privacy mode 1430. For example, the processor 120 may determine that the electronic device 101 is in the normal mode 1440 when the application 146 being executed or the screen displayed on the display 210 is a home menu, a settings menu, an always on display (AOD), a video player, a music player, a game, a News, or a community web browser. In the normal mode 1440, the display 210 may display the screen at the first viewing angle. The processor 120 may be set to control a display driver IC (e.g., the display driver IC 230 in FIG. 2) that drives the display 210 to drive a plurality of light emitting elements (e.g., the light emitting element 320 in FIG. 3) arranged in a first area (e.g., the first area A1 in FIG. 3) and a second area (e.g., the second area A2 in FIG. 3) of the display 210 in the normal mode 1440.

In operation 1525, the processor 120 of the electronic device 101 according to an embodiment may determine whether an app (e.g., the application 146 in FIG. 1) or a page has been switched. The processor 120 may return to operation 1510 when the app 146 executed in the electronic device 101 or the screen or the page displayed on the display 210 is switched (operation 1525 - YES). The processor 120 may maintain operation 1520 when the app 146 executed in the electronic device 101 or the screen or the page displayed on the display 210 is maintained (operation 1525 - NO).

The processor 120 of the electronic device 101 according to an embodiment may be driven in the privacy mode 1430 in operation 1530. The processor 120 may drive the electronic device 101 in the privacy mode 1430 when the type of the application 146 being executed in the electronic device 101 or the screen displayed on the display 210 corresponds to the privacy mode 1430. In the privacy mode 1430, the display 210 may display the screen at the second viewing angle that is narrower than the first viewing angle. The processor 120 may be set to control a display driver IC (e.g., the display driver IC 230 in FIG. 2) that drives the display 210 to drive a plurality of light emitting elements (e.g., the light emitting element 320 in FIG. 3) arranged in a second area (e.g., the second area A2 in FIG. 3) of the display 210 in the privacy mode 1430.

The processor 120 of the electronic device 101 according to an embodiment may determine whether the app 146 or the page has been switched in operation 1535. The processor 120 may return to operation 1510 when the app 146 executed in the electronic device 101 or the screen or the page displayed on the display 210 is switched (operation 1535 - YES). The processor 120 may maintain operation 1523 when the app 146 executed in the electronic device 101 or the screen or the page displayed on the display 210 is maintained (operation 1535 - NO).

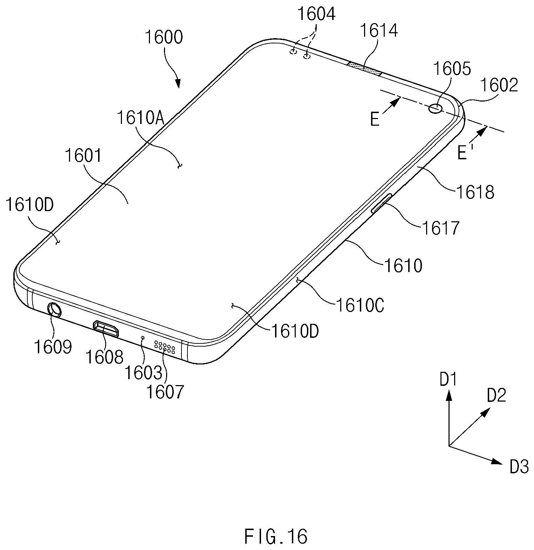

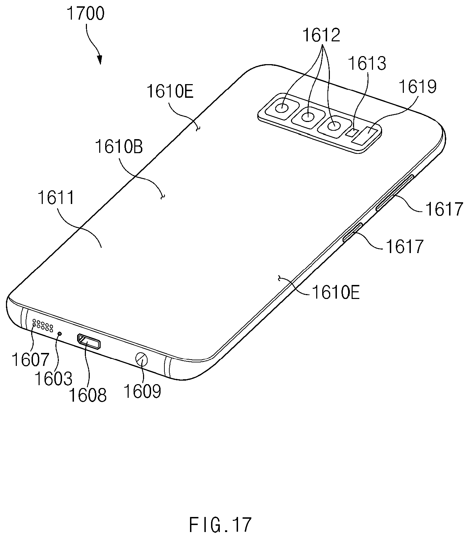

FIG. 16 is a front perspective view 1600 of an electronic device (e.g., the electronic device 101 in FIG. 1) according to an embodiment. FIG. 17 is a rear perspective view 1700 of the electronic device 101 according to an embodiment.

Referring to FIGS. 16 and 17, the electronic device 101 according to an embodiment may include a housing 1610. The housing 1610 may include a first surface (or a front surface) 1610A, a second surface (or a rear surface) 1610B, and a side surface 1610C for surrounding a space between the first surface 1610A and the second surface 1610B. According to an embodiment, the housing 1610 may refer to some of the first surface 1610A, the second surface 1610B, and the side surface 1610C in FIG. 16. The first surface 1610A of the housing 1610 may include a front plate 1602 (e.g., a glass plate or a polymer plate including various coating layers) that is at least partially transparent. The second surface 1610B of the housing 1610 may include a substantially opaque rear plate 1611. For example, the rear plate 1611 may contain a coated or tinted glass, a ceramic, a polymer, a metal (e.g., aluminum, stainless steel (STS), or magnesium), or a combination of at least two of the above-described materials. The side surface 1610C of the housing 1610 may include a side bezel structure 1618 (or a "side member") coupled with the front plate 1602 and the rear plate 1611 and containing the metal and/or the polymer. According to an embodiment, the rear plate 1611 and the side bezel structure 1618 may be integrally formed with each other or may contain the same material (e.g., the metal material such as the aluminum).

The front plate 1602 may include a first edge area 1610D that is bent from the first surface 1610A toward the rear plate 1611 and extends seamlessly. The first edge area 1610D of the front plate 1602 may be located at each of long edges at both sides of the front plate 1602. The rear plate 1611 may include a second edge area 1610E that is bent from the second surface 1610B toward the front plate 1602 and extends seamlessly. The second edge area 1610E may be located at each of long edges at both sides of the rear plate 2011. According to an embodiment, the electronic device 101 may include only one of the first edge area 1610D of the front plate 1602 or the second edge area 1610E of the rear plate 1611. According to an embodiment, the front plate 1602 and the rear plate 1611 may not include the first edge area 1610D and the second edge area 1610E. In an area not including the first edge area 1610D or the second edge area 1610E, the side bezel structure 1618 may have a first thickness (or width). In an area including the first edge area 1610D or the second edge area 1610E, the side bezel structure 1618 may have a second thickness smaller than the first thickness.

The electronic device 101 according to an embodiment may include at least one of a display 1601, an input device 1603, sound output devices 1607 and 1614, sensor modules 1604 and 1619, camera modules 1605, 1612, and 1613, a key input device 1617, an indicator (not shown), and connectors 1608 and 1609. According to an embodiment, the electronic device 101 may omit at least one (e.g., the key input device 1617 or the indicator) of the components or additionally include another component.

The display 1601 may be viewed through a significant portion of the front plate 1602. According to an embodiment, at least a portion of the display 1601 may be viewed through the first surface 1610A and the first edge area 1610D of the front plate 1602. The display 1601 may be coupled to or disposed adjacent to a touch sensing circuit, a pressure sensor capable of measuring an intensity (a pressure) of a touch, and/or a digitizer for detecting a magnetic field type stylus pen. At least a portion of each of the sensor modules 1604 and 1619 and/or at least a portion of the key input device 1617 may be disposed in the first edge area 1610D and/or the second edge area 1610E.

The input device 1603 may include a microphone. In some embodiments, the input device 1603 may include a plurality of microphones arranged to sense a direction of the sound.

The sound output devices 1607 and 1614 may include speakers. The sound output devices 1607 and 1614 may include the external speaker 1607 and the receiver 1614 for a call. The input device 1603, the sound output devices 1607 and 1614, and the connectors 1608 and 1609 may be exposed to an external environment via at least one hole defined in the housing 1610. According to an embodiment, the hole defined in the housing 1610 may be used in common for the input device 1603 and the sound output devices 1607 and 1614. According to an embodiment, the sound output devices 1607 and 1614 may include a speaker (e.g., a piezo speaker) operated without the hole in the housing 1610.

The sensor modules 1604 and 1619 may generate an electrical signal or a data value corresponding to an internal operating state or an external environmental state of the electronic device 101. For example, the sensor modules 1604 and 1619 may include the first sensor module 1604 (e.g., a proximity sensor) and a second sensor module (not shown) (e.g., a fingerprint sensor) arranged on the first surface 1610A of the housing 1610 and/or the third sensor module 1619 (e.g., an HRM sensor) disposed on the second surface 1610B of the housing 1610. The fingerprint sensor may be disposed in the first surface 1610A (e.g., a home key button), a partial area of the second surface 1610B of the housing 1610, or below the display 1601. The electronic device 101 according to an embodiment may further include at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules 1605, 1612, and 1613 may include the first camera device 1605 disposed on the first surface 1610A of the electronic device 101, and the second camera device 1612 and/or the flash 1613 arranged on the second surface 1610B. Each of the first camera device 1605 and the second camera device 1612 may include one or a plurality of lenses, an image sensor, and/or an image signal processor. For example, the flash 1613 may include a light emitting diode or a xenon lamp. In some embodiment, the two or more lenses (e.g., a wide-angle lens, an ultra-wide-angle lens, or a telephoto lens) and the image sensors may be arranged on one surface of the electronic device 101.

The key input device 1617 may be disposed on the side surface 1610C of the housing 1610. According to an embodiment, the electronic device 101 may not include some or all of the key input devices 1617 and the not included key input device 1617 may be implemented in a form of a soft key or the like on the display 1601. In another embodiment, the key input device 1617 may be implemented using the pressure sensor included in the display 1601.

The indicator may be disposed on the first surface 1610A of the housing 1610. The indicator may provide state information of the electronic device 101 in an optical form. The light emitting element may provide a light source that is in association with an operation of the camera module 1605. The indicator may include an LED, an IR LED, and the xenon lamp.

The connector holes 1608 and 1609 may include the first connector hole 1608 that may accommodate therein a connector (e.g., a USB connector) for transmitting and receiving power and/or data to and from the external electronic device and/or the second connector hole (or an earphone jack) 1609 capable of accommodating therein a connector for transmitting and receiving an audio signal to and from the external electronic device.

The first camera device 1605, the first sensor module 1604, or an indicator may be arranged to be visible through the display 1601. For example, the first camera device 1605, the first sensor module 1604, or the indicator may be located in an internal space of the electronic device 101 and may be in contact with the external environment through a through-hole extending to the front plate 1602 of the display 1601. In another embodiment, the first sensor module 1604 may be disposed to perform the function thereof without being visually exposed through the front plate 1602 in the internal space of the electronic device. In this case, the through-hole may not be needed in an area of the display 1601 facing the first sensor module 1604.

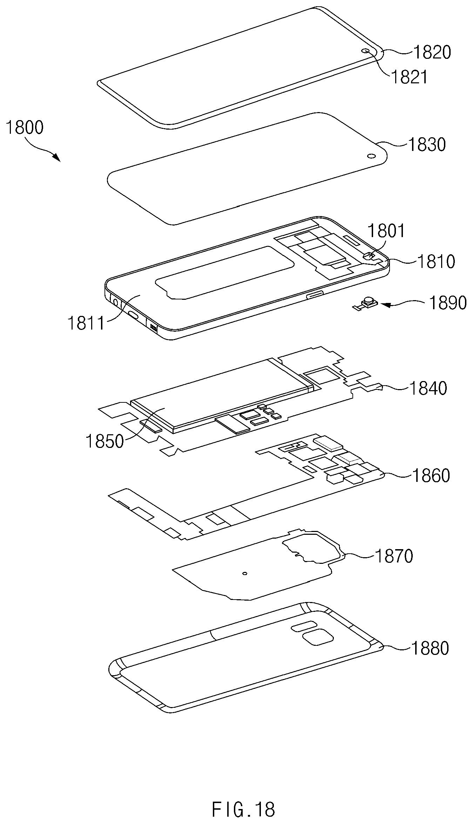

FIG. 18 is an exploded perspective view 1800 of an electronic device (e.g., the electronic device 101 in FIG. 1) according to an embodiment. The electronic device 101 according to an embodiment may be at least partially similar to the electronic device 101 in FIGS. 16 and 17, or may further include another embodiment of the electronic device 101.

Referring to FIG. 18, the electronic device 101 may include a side member 1810 (e.g., the side bezel structure 1618 in FIG. 16), a first support member 1811 (e.g., a bracket or a support structure), a front plate 1820 (e.g., a front surface cover), a display 1830, a printed circuit board 1840, a battery 1850, a second support member 1860 (e.g. a rear case), an antenna 1870, and a rear plate 1880 (e.g., a rear cover). The electronic device 101 according to an embodiment may omit at least one (e.g., the first support member 1811 or the second support member 1860) of the components or additionally include another component. At least one of the components of the electronic device 101 may be the same as or similar to at least one of the components of the electronic device 101 in FIG. 16 or 17, and duplicated descriptions will be omitted below.

The first support member 1811 may be disposed inside the electronic device 101 and connected to the side member 1810 or integrally formed with the side member 1810. For example, the first support member 1811 may contain a metal material and/or a non-metal (e.g., a polymer) material. The first support member 1811 may have one surface coupled with the display 1830 and the other surface coupled with the printed circuit board 1840. A processor, a memory, and/or an interface may be mounted on the printed circuit board 1840. The processor may include one of a central processing unit, an application processor, a graphic processing unit, an image signal processor, a sensor hub processor, or a communication processor. The memory may include a volatile memory or a non-volatile memory. The interface may include a high definition multimedia interface (HDMI), a universal serial bus (USB) interface, an SD card interface, and/or an audio interface. For example, the interface may electrically or physically connect the electronic device 101 to the external electronic device, and may include the USB connector, the SD card/MMC connector, or the audio connector.

The battery 1850 may supply the power to the at least one component of the electronic device 101. For example, the battery 1850 may include a non-rechargeable primary cell, a rechargeable secondary cell, or a fuel cell. At least a portion of the battery 1850 may be disposed substantially on the same plane as the printed circuit board 1840. The battery 1850 may be integrally formed with and disposed inside the electronic device 101. In another embodiment, the battery 180 may be disposed detachably from the electronic device 101.

The antenna 1870 may be disposed between the rear plate 1880 and the battery 1850. For example, the antenna 1870 may include a near field communication (NFC) antenna, a wireless charging antenna, and/or a magnetic secure transmission (MST) antenna. The antenna 1870 may perform short-range communication with the external device or wirelessly transmit/receive the power required for the charging. In another embodiment, the antenna may be formed by some of the side member 1810 and/or the first support member 1811 or a combination thereof.

According to one embodiment, the camera module 1890 (e.g., the camera module 1605 in FIG. 16) may be disposed between the first support member 1811 and the rear plate 1880. According to one embodiment, the camera module 1890 may be disposed to be directed in a direction of the front plate 1820 through a through-hole 1801 extending through both surfaces of the first support member 1811. According to one embodiment, a portion protruding through the through-hole 1801 in the camera module 1890 may be disposed to be close to a rear surface of the front plate 1820 through at least one opening defined in a corresponding position of the display 1830. In another embodiment, when the camera module 1890 is disposed between the display 1830 and the first support member 1811, the through-hole 1801 may be unnecessary. According to one embodiment, in the internal space of the electronic device 101, the camera module 1890 may be at least partially disposed in the through-hole 1801 and the at least one opening of the display. The camera module 1890 may be disposed to detect the external environment through a camera exposure area 1821 of the front plate 1820.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor(e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:

   a housing;
   a display (210) viewed through at least a portion of the housing and displaying a screen using a plurality of pixels;
   a display driver IC (230) for providing a data voltage and a light-emission signal for driving each of the plurality of pixels to the display; and
   a processor (120) operatively connected to the display driver IC (230),
   wherein the display includes:

      a transistor layer (310) including a plurality of light emitting elements (320);
      an encapsulation layer (330) for covering the transistor layer (310);
      a touch electrode (340) disposed on the encapsulation layer (330); and
      a protective layer (350) disposed on the touch electrode (340),

   wherein the protective layer (350) includes a first area (A1) where a first protective layer (351) having a first refractive index (n1) is disposed and a second area (A2) where a second protective layer (352) having a second refractive index (n2) different from the first refractive index (n1) is disposed,
   wherein the second area (A2) is disposed to overlap with at least one of the plurality of light emitting elements (320) in a first direction,
   wherein a first boundary (353) that is an interface between the first protective layer (351) and the second protective layer (352) forms an inclination of a first angle with the first direction, and
   wherein the processor is configured to:

control the display driver IC (230) to drive the plurality of light emitting elements (320) arranged in the first area (A1) and the second area (A2) when the display is in a normal mode for displaying the screen at a first viewing angle; and

control the display driver IC (230) to only drive the plurality of light emitting elements (320) arranged in the second area (A2) when the display is in a privacy mode for displaying the screen at a second viewing angle narrower than the first viewing angle.

2. The electronic device of claim 1, wherein the second refractive index is greater than the first refractive index.

3. The electronic device of claim 2, wherein the first angle is set based on a first distance (T1) that is a distance in the first direction between the at least one light emitting element (320) and the second protective layer (352), and a second distance (D1) that is a distance in a second direction perpendicular to the first direction between the at least one light emitting element (320) and the first boundary (351).

4. The electronic device of claim 2, wherein light emitted from the at least one light emitting element includes first light (L1) traveling in the first direction and second light (L2) traveling toward the first boundary, wherein the first boundary (351) controls the second light (L2) in a direction of increasing a light component in the first direction.

5. The electronic device of claim 1, wherein the display (210) further includes a window (360) disposed on the protective layer (350),

   wherein the second refractive index is smaller than the first refractive index,
   wherein the first boundary controls second light in a direction of decreasing a light component in the first direction.

6. The electronic device of claim 1, wherein the plurality of light emitting elements include a plurality of sub-pixels included in one of the plurality of pixels and emitting light with a specified color, wherein the second area includes sub-pixels of different colors of the plurality of sub-pixels, and the number of each of the sub-pixels of the different colors is equal to or greater than one.

7. The electronic device of claim 1, wherein the first boundary is formed between each two of the plurality of pixels.

8. An electronic device comprising:

   a housing;
   a display (210) viewed through at least a portion of the housing and displaying a screen using a plurality of pixels;
   a display driver IC (230) for providing a data voltage and a light-emission signal for driving each of the plurality of pixels to the display; and
   a processor (120) operatively connected to the display driver IC,
   wherein the display includes:

      a transistor layer (310) including a plurality of light emitting elements (320);
      an encapsulation layer (330) for covering the transistor layer (310);
      a touch electrode (340) disposed on the encapsulation layer (330); and
      a protective layer (350) disposed on the touch electrode,

   wherein the encapsulation layer (330) includes a first area (A1) where a first encapsulation layer (331) having a first refractive index (n1) is disposed and a second area (A2) where a second encapsulation layer (332) having a second refractive index (n2) different from the first refractive index (n1) is disposed,
   wherein the second area (A2) is disposed to overlap with at least one of the plurality of light emitting elements (320) in a first direction,
   wherein an interface (333) between the first encapsulation layer (331) and the second encapsulation layer (332) forms an inclination of a first angle with the first direction, and wherein the display driver IC (120) is controlled to drive the plurality of light emitting elements (320) arranged in the first area (A1) and the second area (A2) when the display is in a normal mode for displaying the screen at a first viewing angle,
   wherein the display driver IC (120) is controlled to only drive the plurality of light emitting elements (320) arranged in the second area (A2) when the display is in a privacy mode for displaying the screen at a second viewing angle narrower than the first viewing angle.

9. The electronic device of claim 8, wherein the second refractive index (n2) is greater than the first refractive index (n1), wherein the interface (333) controls second light in a direction of increasing a light component in the first direction.

10. The electronic device of claim 9, wherein the first angle is set based on a third distance (T2) that is a distance in the first direction between the at least one light emitting element (320) and the second encapsulation layer (332), and a fourth distance (D2) that is a distance in a second direction perpendicular to the first direction between the at least one light emitting element (320) and the interface (333).

11. The electronic device of claim 8, further comprising:

   a window (360) disposed on the protective layer (350),
   wherein the second refractive index is smaller than the first refractive index,
   wherein the first boundary controls second light in a direction of decreasing a light component in the first direction.

12. The electronic device of claim 8, wherein the plurality of light emitting elements include a plurality of sub-pixels included in one of the plurality of pixels and emitting light with a specified color,
   wherein the second area includes sub-pixels of different colors of the plurality of sub-pixels, and the number of each of the sub-pixels of the different colors is equal to or greater than one.

13. The electronic device of claim 8, wherein the first boundary is formed between each two of the plurality of pixels.


**Patentansprüche**

1. Elektronische Vorrichtung, umfassend:

   ein Gehäuse;
   eine Anzeige (210), die durch mindestens einen Abschnitt des Gehäuses betrachtet wird und einen Bildschirm mittels einer Vielzahl von Pixeln anzeigt;
   eine Anzeigetreiber-IC (230) zum Bereitstellen einer Datenspannung und eines Lichtemissionssignals zum Ansteuern jedes der Vielzahl von Pixeln an der Anzeige; und
   einen Prozessor (120), der mit der Anzeigetreiber-IC (230) wirkverbunden ist,
   wobei die Anzeige umfasst:

      eine Transistorschicht (310), die eine Vielzahl von lichtemittierenden Elementen (320) enthält;
      eine Verkapselungsschicht (330) zum Abdecken der Transistorschicht (310);
      eine Berührungselektrode (340), die auf der Verkapselungsschicht (330) angeordnet ist; und
      eine Schutzschicht (350), die auf der Berührungselektrode (340) angeordnet ist,

   wobei die Schutzschicht (350) einen ersten Bereich (A1), in dem eine erste Schutzschicht (351) mit einem ersten Brechungsindex (n1) angeordnet ist, und einen zweiten Bereich (A2), in dem eine zweite Schutzschicht (352) mit einem zweiten Brechungsindex (n2), der sich von dem ersten Brechungsindex (n1) unterscheidet, angeordnet ist, umfasst,
   wobei der zweite Bereich (A2) so angeordnet ist, dass er mit mindestens einem der Vielzahl von lichtemittierenden Elementen (320) in einer ersten Richtung überlappt,
   wobei eine erste Grenze (353), die eine Schnittstelle zwischen der ersten Schutzschicht (351) und der zweiten Schutzschicht (352) ist, eine Neigung eines ersten Winkels mit der ersten Richtung bildet, und
   wobei der Prozessor konfiguriert ist zum:

      Steuern der Anzeigetreiber-IC (230), um die Vielzahl von lichtemittierenden Elementen (320) anzusteuern, die im ersten Bereich (A1) und im zweiten Bereich (A2) angeordnet sind, wenn sich die Anzeige in einem normalen Modus befindet, um den Bildschirm in einem ersten Betrachtungswinkel anzuzeigen; und
      Steuern der Anzeigetreiber-IC (230), um die Vielzahl von lichtemittierenden Elementen (320), die im zweiten Bereich (A2) angeordnet sind, nur dann anzusteuern, wenn sich die Anzeige in einem Datenschutzmodus befindet, um den Bildschirm in einem zweiten Betrachtungswinkel, der kleiner als der erste Betrachtungswinkel ist, anzuzeigen.

2. Elektronische Vorrichtung nach Anspruch 1, wobei der zweite Brechungsindex größer ist als der erste Brechungsindex.

3. Elektronische Vorrichtung nach Anspruch 2, wobei der erste Winkel basierend auf einem ersten Abstand (T1), der ein Abstand in der ersten Richtung zwischen dem mindestens einen lichtemittierenden Element (320) und der zweiten Schutzschicht (352) ist, und einem zweiten Abstand (D1), der ein Abstand in einer zweiten Richtung senkrecht zu der ersten Richtung zwischen dem mindestens einen lichtemittierenden Element (320) und der ersten Grenze (351) ist, eingestellt ist.

4. Elektronische Vorrichtung nach Anspruch 2, wobei das von dem mindestens einen lichtemittierenden Element emittierte Licht ein erstes Licht (L1), das sich in die erste Richtung bewegt, und ein zweites Licht (L2), das sich in Richtung der ersten Grenze bewegt, enthält,
wobei die erste Grenze (351) das zweite Licht (L2) in eine Richtung steuert, in der eine Lichtkomponente in der ersten Richtung erhöht wird.

5. Elektronische Vorrichtung nach Anspruch 1, wobei die Anzeige (210) ferner ein Fenster (360) enthält, das auf der Schutzschicht (350) angeordnet ist,

> wobei der zweite Brechungsindex kleiner ist als der erste Brechungsindex,
> wobei die erste Grenze das zweite Licht in einer Richtung steuert, in der eine Komponente des Lichts in der ersten Richtung abnimmt.

6. Elektronische Vorrichtung nach Anspruch 1, wobei die Vielzahl von lichtemittierenden Elementen eine Vielzahl von Subpixeln enthält, die in einem der Vielzahl von Pixeln enthalten sind und Licht mit einer bestimmten Farbe emittieren, wobei der zweite Bereich Subpixel verschiedener Farben der Vielzahl von Subpixeln enthält, und die Anzahl jedes der Subpixel der verschiedenen Farben gleich oder größer als eins ist.

7. Elektronische Vorrichtung nach Anspruch 1, wobei die erste Grenze zwischen jeweils zwei der Vielzahl von Pixeln ausgebildet ist.

8. Elektronische Vorrichtung, umfassend:

> ein Gehäuse;
> eine Anzeige (210), die durch mindestens einen Abschnitt des Gehäuses betrachtet wird und einen Bildschirm mittels einer Vielzahl von Pixeln anzeigt;
> eine Anzeigetreiber-IC (230) zum Bereitstellen einer Datenspannung und eines Lichtemissionssignals zum Ansteuern jedes der Vielzahl von Pixeln an der Anzeige; und
> einen Prozessor (120), der mit der Anzeigetreiber-IC wirkverbunden ist,
> wobei die Anzeige umfasst:

>> eine Transistorschicht (310), die eine Vielzahl von lichtemittierenden Elementen (320) enthält;
>> eine Verkapselungsschicht (330) zum Abdecken der Transistorschicht (310);
>> eine Berührungselektrode (340), die auf der Verkapselungsschicht (330) angeordnet ist; und
>> eine Schutzschicht (350), die auf der Berührungselektrode angeordnet ist,

> wobei die Verkapselungsschicht (330) einen ersten Bereich (A1), in dem eine erste Verkapselungsschicht (331) mit einem ersten Brechungsindex (n1) angeordnet ist, und einen zweiten Bereich (A2), in dem eine zweite Verkapselungsschicht (332) mit einem zweiten Brechungsindex (n2), der sich von dem ersten Brechungsindex (n1) unterscheidet, angeordnet ist, umfasst,
> wobei der zweite Bereich (A2) so angeordnet ist, dass er mit mindestens einem der Vielzahl von lichtemittierenden Elementen (320) in einer ersten Richtung überlappt,
> wobei eine Schnittstelle (333) zwischen der ersten Verkapselungsschicht (331) und der zweiten Verkapselungsschicht (332) eine Neigung eines ersten Winkels mit der ersten Richtung bildet, und
> wobei die Anzeigetreiber-IC (120 gesteuert wird, um die Vielzahl von lichtemittierenden Elementen (320), die in dem ersten Bereich (A1) und dem zweiten Bereich (A2) angeordnet sind, nur dann anzusteuern, wenn sich die Anzeige in einem normalen Modus befindet, um den Bildschirm in einem ersten Betrachtungswinkel anzuzeigen,
> wobei die Anzeigetreiber-IC (120) gesteuert wird, um die Vielzahl von lichtemittierenden Elementen (320), die im zweiten Bereich (A2) angeordnet sind, anzusteuern, wenn sich die Anzeige in einem Datenschutzmodus befindet, um den Bildschirm in einem zweiten Betrachtungswinkel, der kleiner als der erste Betrachtungswinkel ist, anzuzeigen.

9. Elektronische Vorrichtung nach Anspruch 8, wobei der zweite Brechungsindex (n2) größer ist als der erste Brechungsindex (n1), wobei die Schnittstelle (333) das zweite Licht in einer Richtung steuert, in der eine Komponente des Lichts in der ersten Richtung zunimmt.

10. Elektronische Vorrichtung nach Anspruch 9, wobei der erste Winkel basierend auf einem dritten Abstand (T2), der ein Abstand in der ersten Richtung zwischen dem mindestens einen lichtemittierenden Element (320) und der zweiten Verkapselungsschicht (332) ist, und einem vierten Abstand (D2), der ein Abstand in einer zweiten Richtung senkrecht zu der ersten Richtung zwischen dem mindestens einen lichtemittierenden Element (320) und der Schnittstelle (333) ist, eingestellt ist.

11. Elektronische Vorrichtung nach Anspruch 8, ferner umfassend:

   ein Fenster (360), das auf der Schutzschicht (350) angeordnet ist,
   wobei der zweite Brechungsindex kleiner ist als der erste Brechungsindex,
   wobei die erste Grenze das zweite Licht in einer Richtung steuert, in der eine Komponente des Lichts in der ersten Richtung abnimmt.

12. Elektronische Vorrichtung nach Anspruch 8, wobei die Vielzahl von lichtemittierenden Elementen eine Vielzahl von Subpixeln enthält, die in einem der Vielzahl von Pixeln enthalten sind und Licht mit einer bestimmten Farbe emittieren, wobei der zweite Bereich Subpixel verschiedener Farben der Vielzahl von Subpixeln enthält, und die Anzahl jedes der Subpixel der verschiedenen Farben gleich oder größer als eins ist.

13. Elektronische Vorrichtung nach Anspruch 8, wobei die erste Grenze zwischen jeweils zwei der Vielzahl von Pixeln ausgebildet ist.

**Revendications**

1. Dispositif électronique, comprenant :

   un boîtier;
   un affichage (210) vu à travers au moins une partie du boîtier et affichant un écran à l'aide d'une pluralité de pixels ;
   un IC de commande d'affichage (230) pour fournir une tension de données et un signal d'émission de lumière pour commander chacun de la pluralité de pixels à l'affichage ; et
   un processeur (120) connecté de manière opérationnelle a l'IC de commande d'affichage (230),
   dans lequel l'affichage (160) comprend :

      une couche de transistor (310) comprenant une pluralité d'éléments émetteurs de lumière (320) ;
      une couche d'encapsulation (330) destinée à recouvrir la couche de transistor (310) ;
      une électrode tactile (340) disposée sur la couche d'encapsulation (330) ; et
      une couche de protection (350) disposée dans l'électrode tactile (340),

   dans lequel la couche de protection (350) comprend une première zone (A1) où est disposée une première couche de protection (351) ayant un premier indice de réfraction (n1) et une deuxième zone (A2) où est disposée une deuxième couche de protection (352) ayant un deuxième indice de réfraction (n2) différent du premier indice de réfraction (n1),
   dans lequel la deuxième zone (A2) est disposée de manière à se superposer à au moins un de la pluralité d'éléments émetteurs de lumière (320) dans une première direction,
   dans lequel une première limite (353) qui est une interface entre la première couche de protection (351) et la deuxième couche de protection (352) forme une inclinaison d'un premier angle avec la première direction, et
   dans lequel le processeur est configuré pour :

      commander l'IC de commande d'affichage (230) pour piloter la pluralité d'éléments émetteurs de lumière (320) disposés dans la première zone (A1) et la deuxième zone (A2) lorsque l'affichage est en mode normal pour afficher l'écran à un premier angle de vue ; et

commander l'IC de commande d'affichage (230) pour qu'il commande uniquement la pluralité d'éléments émetteurs de lumière (320) disposés dans la deuxième zone (A2) lorsque l'affichage est dans un mode de confidentialité pour afficher l'écran à un deuxième angle de vue plus étroit que le premier angle de vue.

2. Dispositif électronique de la revendication 1, dans lequel le deuxième indice de réfraction est supérieur au premier indice de réfraction.

3. Dispositif électronique de la revendication 2, dans lequel le premier angle est défini sur la base d'une première distance (T1) qui est une distance dans la première direction entre l'au moins un élément émetteur de lumière (320) et la deuxième couche de protection (352), et d'une deuxième distance (D1) qui est une distance dans une deuxième direction perpendiculaire à la première limite (351).

4. Dispositif électronique de la revendication 2, dans lequel la lumière émise par l'au moins un élément émetteur de lumière comprend une première lumière (L1) se déplaçant dans la première direction et une deuxième lumière (L2) se déplaçant vers la première limite,
dans lequel la première limite (351) commande la deuxième lumière (L2) dans le sens de l'augmentation d'un composant de lumière dans la première direction.

5. Dispositif électronique de la revendication 1, dans lequel l'affichage (210) comprend en outre une fenêtre (360) disposée sur la couche de protection (350),

dans lequel le deuxième indice de réfraction est inférieur au premier indice de réfraction,
dans lequel la première limite commande la deuxième lumière dans une direction de diminution d'un composant de lumière dans la première direction.

6. Dispositif électronique de la revendication 1, dans lequel la pluralité d'éléments émetteurs de lumière comprend une pluralité de sous-pixels inclus dans l'un de la pluralité de pixels et émettant de la lumière avec une couleur spécifiée, dans lequel la deuxième zone comprend des sous-pixels de couleurs différentes de la pluralité de sous-pixels, et le nombre de chacun des sous-pixels de couleurs différentes est égal ou supérieur à un.

7. Dispositif électronique de la revendication 1, dans lequel la première limite est formée entre chacun de deux de la pluralité de pixels.

8. Dispositif électronique, comprenant :

un boîtier;
un affichage (210) vu à travers au moins une partie du boîtier et affichant un écran à l'aide d'une pluralité de pixels ;
un IC de commande d'affichage (230) pour fournir une tension de données et un signal d'émission de lumière pour commander chacun de la pluralité de pixels à l'affichage ; et
un processeur (120) connecté de manière opérationnelle à l'IC de commande d'affichage,
dans lequel l'affichage (160) comprend :

une couche de transistor (310) comprenant une pluralité d'éléments émetteurs de lumière (320) ;
une couche d'encapsulation (330) destinée à recouvrir la couche de transistor (310) ;
une électrode tactile (340) disposée sur la couche d'encapsulation (330) ; et
une couche de protection (350) disposée sur l'électrode tactile,

dans lequel la couche d'encapsulation (330) comprend une première zone (A1) où est disposée une première couche d'encapsulation (331) ayant un premier indice de réfraction (n1) et une deuxième zone (A2) où est disposée une deuxième couche d'encapsulation (332) ayant un deuxième indice de réfraction (n2) différent du premier indice de réfraction (n1),
dans lequel la deuxième zone (A2) est disposée de manière à se superposer à au moins un de la pluralité d'éléments émetteurs de lumière (320) dans une première direction,
dans lequel une interface (333) entre la première couche d'encapsulation (331) et la deuxième couche d'encapsulation (332) forme une inclinaison d'un premier angle avec la première direction, et
dans lequel l'IC de commande d'affichage (120) est commandé de manière à commander uniquement la pluralité d'éléments émetteurs de lumière (320) disposés dans la première zone (A1) et la deuxième zone (A2) lorsque l'affichage est dans un mode normal d'affichage de l'écran à un premier angle de vue,

dans lequel l'IC de commande d'affichage (120) est commandé pour commander la pluralité d'éléments émetteurs de lumière (320) disposés dans la deuxième zone (A2) lorsque l'affichage est dans un mode de confidentialité pour afficher l'écran à un deuxième angle de vue plus étroit que le premier angle de vue.

9. Dispositif électronique de la revendication 8, dans lequel le deuxième indice de réfraction (n2) est supérieur au premier indice de réfraction (n1),
dans lequel l'interface (333) commande la deuxième lumière dans une direction d'augmentation d'un composant de lumière dans la première direction.

10. Dispositif électronique de la revendication 9, dans lequel le premier angle est défini sur la base d'une troisième distance (T2) qui est une distance dans la première direction entre l'au moins un élément émetteur de lumière (320) et la deuxième couche d'encapsulation (332), et d'une quatrième distance (D2) qui est une distance dans une deuxième direction perpendiculaire à la première direction entre l'au moins un élément émetteur de lumière (320) et l'interface (333).

11. Dispositif électronique de la revendication 8, comprenant en outre :

une fenêtre (360) disposée sur la couche d'encapsulation (350),
dans lequel le deuxième indice de réfraction est inférieur au premier indice de réfraction,
dans lequel la première limite commande la deuxième lumière dans une direction de diminution d'un composant de lumière dans la première direction.

12. Dispositif électronique de la revendication 8, dans lequel la pluralité d'éléments émetteurs de lumière comprend une pluralité de sous-pixels inclus dans l'un de la pluralité de pixels et émettant de la lumière avec une couleur spécifiée,
dans lequel la deuxième zone comprend des sous-pixels de couleurs différentes de la pluralité de sous-pixels, et le nombre de chacun des sous-pixels de couleurs différentes est égal ou supérieur à un.

13. Dispositif électronique de la revendication 8, dans lequel la première limite est formée entre chacun de deux de la pluralité de pixels.

FIG.1

<u>200</u>

```
┌─────────────────────────────────────────────────────────────────┐
│                    DISPLAY DEVICE 160                            │
│  ┌──────────────────────────────────────┐  ┌─────────────────┐  │
│  │         DISPLAY DRIVER IC 230         │  │                 │  │
│  │  ┌─────────────────┐ ┌─────────────┐  │  │                 │  │
│  │  │ INTERFACE MODULE│ │ MEMORY 233  │  │  │                 │  │
│  │  │      231        │ │             │  │  │  DISPLAY 210    │  │
│  │  └─────────────────┘ └─────────────┘  │  │                 │  │
│  │  ┌─────────────────┐ ┌─────────────┐  │  │                 │  │
│  │  │ IMAGE PROCESSING│ │MAPPING MODULE│ │  │                 │  │
│  │  │ MODULE      235 │ │     237     │  │  │                 │  │
│  │  └─────────────────┘ └─────────────┘  │  │                 │  │
│  └──────────────────────────────────────┘  │                 │  │
│  ┌──────────────────────────────────────┐  └─────────────────┘  │
│  │         TOUCH CIRCUITRY 250           │  ┌ ─ ─ ─ ─ ─ ─ ─ ─┐  │
│  │  ┌─────────────────┐ ┌─────────────┐  │    SENSOR          │
│  │  │ TOUCH SENSOR 251│ │TOUCH SENSOR │  │  │ MODULE   176   │  │
│  │  │                 │ │   IC 253    │  │                     │
│  │  └─────────────────┘ └─────────────┘  │  └ ─ ─ ─ ─ ─ ─ ─ ─┘  │
│  └──────────────────────────────────────┘                       │
└─────────────────────────────────────────────────────────────────┘
```

FIG.2

FIG.3

EP 4 099 417 B1

FIG.4

EP 4 099 417 B1

FIG.5

FIG.6

EP 4 099 417 B1

FIG.7

EP 4 099 417 B1

FIG.8

FIG.9

FIG.10

FIG.11

FIG.12

FIG.13

FIG.14

FIG.15

EP 4 099 417 B1

FIG.16

FIG.17

FIG.18

**EP 4 099 417 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20190165061 A1
- CN 109904347 A
- US 20190074339 A1
- US 20150008399 A1